(19) Europäisches Patentamt
European Patent Office
Office européen des brevets

(11) **EP 2 382 481 B1**

(12) **FASCICULE DE BREVET EUROPEEN**

(45) Date de publication et mention
de la délivrance du brevet:
**16.01.2013 Bulletin 2013/03**

(51) Int Cl.:
***G01R 33/022*** *(2006.01)*    ***G01R 33/028*** *(2006.01)*
***G01R 33/038*** *(2006.01)*

(21) Numéro de dépôt: **10701660.2**

(22) Date de dépôt: **22.01.2010**

(86) Numéro de dépôt international:
**PCT/EP2010/050710**

(87) Numéro de publication internationale:
**WO 2010/084165 (29.07.2010 Gazette 2010/30)**

(54) **CAPTEUR DE CHAMP MAGNETIQUE A JAUGE DE CONTRAINTE SUSPENDUE**

MAGNETFELDSENSOR MIT FREI AUFGEHÄNGTER BELASTUNGSMESSVORRICHTUNG

MAGNETIC FIELD SENSOR WITH SUSPENDED STRESS GAUGE

(84) Etats contractants désignés:
**AT BE BG CH CY CZ DE DK EE ES FI FR GB GR
HR HU IE IS IT LI LT LU LV MC MK MT NL NO PL
PT RO SE SI SK SM TR**

(30) Priorité: **26.01.2009 FR 0950463**

(43) Date de publication de la demande:
**02.11.2011 Bulletin 2011/44**

(73) Titulaire: **Commissariat à l'Énergie Atomique
et aux Énergies Alternatives
75015 Paris (FR)**

(72) Inventeurs:
• **WALTHER, Arnaud
F-38000 Grenoble (FR)**
• **ROBERT, Philippe
F-38000 Grenoble (FR)**
• **REDON, Olivier
F-38170 Seyssinet Pariset (FR)**

(74) Mandataire: **Ilgart, Jean-Christophe
BREVALEX
95 rue d'Amsterdam
75378 Paris Cedex 8 (FR)**

(56) Documents cités:
**WO-A2-01/67122**    **US-A1- 2003 020 472**
**US-A1- 2006 076 947**

**EP 2 382 481 B1**

**Description**

**DOMAINE TECHNIQUE**

L'invention concerne le domaine des capteurs magnétiques, et plus particulièrement celui des dispositifs et procédés pour la mesure de champs magnétiques, mono ou multi axes, par un capteur miniature de type MEMS ou NEMS.

Les applications visées sont par exemple la mesure du champ magnétique terrestre pour reconstituer une orientation (application de type boussole), mais également toutes les applications qui font appel à une mesure de champ magnétique (mesure de courant à distance par exemple).

**ÉTAT DE LA TECHNIQUE ANTÉRIEURE**

De nombreuses technologies, basées sur différents principes physiques, ont été développées pour réaliser une mesure de champ magnétique par un capteur miniature. On peut citer notamment les capteurs à effet Hall, les capteurs GMR (à magnétorésistance géante), les capteurs AMR (à magnétorésistance anisotrope), les capteurs fluxgate ou magnétométriques, les capteurs à force de Lorentz ou les capteurs à matériaux magnétiques. US2006/076947, WO01/67122 et US2003/020472 divulguent des capteurs à force de Lorentz de type MEMS comme décrit ici.

Un des problèmes fréquemment rencontrés concerne la fabrication d'un capteur apte à réaliser une mesure de champ magnétique selon plusieurs axes. Des capteurs mesurant les composantes d'un champ magnétique selon 2 axes se trouvant dans le plan du capteur ont déjà été réalisés. Mais dès que l'on souhaite réaliser en plus une mesure de la composante verticale du champ magnétique (composante perpendiculaire au plan du capteur), la réalisation d'un tel capteur devient beaucoup plus complexe, en particulier si l'on souhaite que ce capteur réalise également la mesure des composantes du champ magnétique se trouvant dans le plan du capteur.

De plus, certains types de capteurs ne sont pas adaptés pour réaliser certaines mesures de champ magnétique. Par exemple, pour réaliser une mesure du champ magnétique terrestre, les capteurs à effet Hall ont des résolutions trop faibles pour déterminer avec précision la direction de ce champ magnétique. Les capteurs GMR présentent quant à eux une hystérésis et réalisent une mesure non linéaire à bas champ (inférieure à environ 100 $\mu$T) incompatible avec une mesure du champ magnétique terrestre (égal à environ 50 $\mu$T).

D'autres types de capteurs présentent également une consommation électrique importante, comme par exemple les capteurs AMR et fluxgate, ce qui peut être un inconvénient, par exemple lorsque ces capteurs sont destinés à être utilisés dans des applications embarquées.

Les capteurs à force de Lorentz présentent, lorsque l'on souhaite réaliser une mesure précise d'un champ magnétique tel que le champ magnétique terrestre, des tailles importantes. De plus, leur fonctionnement en mode résonant nécessite des facteurs de qualité importants qui ne peuvent être obtenus que par un packaging sous vide coûteux.

Par rapport aux capteurs à force de Lorentz, les capteurs à matériaux magnétiques durs ne nécessitent pas de courant pour qu'une force ou un couple soit créé en présence d'un champ magnétique, ce qui représente un avantage en termes de consommation électrique. Toutefois, les capteurs à matériaux magnétiques existants présentent d'autres inconvénients majeurs : détection selon seulement 1 ou 2 axes, capteur non intégré, trop grande sensibilité aux accélérations, ou encore trop faible sensibilité de détection de champ magnétique.

**EXPOSÉ DE L'INVENTION**

Un but de la présente invention est donc de proposer un capteur de champ magnétique fortement intégré et compact, par exemple entièrement réalisable en technologie microsystème ou nanosystème, c'est-à-dire de type MEMS ou NEMS, autorisant une détection de champ magnétique mono-axe ou multi-axes, peu sensible aux accélérations et de forte sensibilité magnétique.

Pour cela, l'invention propose un capteur de champ magnétique comportant au moins :

- un corps comprenant des moyens magnétiques aptes à former un couple s'exerçant sur le corps sous l'action d'un champ magnétique extérieur à détecter,
- des moyens de liaison, distincts du corps, reliant mécaniquement le corps à une portion d'encastrement du capteur par au moins une liaison pivot d'axe perpendiculaire à la direction du champ magnétique à détecter,
- des moyens de détection d'une contrainte exercée par le corps sous l'action du couple, distincts des moyens de liaison, comportant au moins une jauge de contrainte suspendue dont au moins une première partie est reliée mécaniquement à la portion d'encastrement, au moins une deuxième partie étant reliée mécaniquement au corps, et dont au moins une troisième partie disposée entre la première et la deuxième partie est suspendue entre la portion d'encastrement et le corps.

2

Un tel dispositif permet notamment de réaliser la mesure des composantes du champ magnétique terrestre (égales à environ 50μT) avec une bonne précision d'orientation (typiquement inférieure à environ 1°). De plus, un tel capteur peut être utilisé dans une application portable et autonome compte tenu de son encombrement réduit, de sa faible masse et de sa consommation électrique potentiellement faible selon les moyens de détection utilisés.

Ce dispositif s'applique également à d'autres types de mesure de champ magnétique, tel que la mesure d'un courant à distance.

Un tel capteur comporte plusieurs parties distinctes : le corps, les moyens de liaison et les moyens de détection. Dans ce capteur, la jauge de contrainte est suspendue entre la portion d'encastrement et le corps. Pour cela, au moins deux parties (par exemple des parties d'extrémité) de la jauge sont reliées mécaniquement (par exemple par une liaison encastrement) à la portion d'encastrement et au corps. Ainsi, au moins une troisième partie de la jauge de contrainte se trouve suspendue entre ces deux éléments, cette troisième partie étant en contact avec aucun élément du capteur, et n'est notamment pas en contact avec les moyens de liaison.

Etant donné que les moyens de détection du champ magnétique sont suspendus, c'est-à-dire décorrélés du corps comportant les moyens magnétiques et du reste du capteur, il est possible d'optimiser indépendamment les unes des autres les différentes parties du capteur, à savoir le corps, les moyens de détection et les moyens de liaison. En particulier, il est possible de réaliser ces trois parties telles qu'elles aient des épaisseurs différentes. Il est également possible de positionner ces moyens de détection à différents endroits et de choisir l'emplacement des moyens de détection afin qu'ils puissent réaliser une bonne mesure de la contrainte exercée par le corps.

De plus, en réalisant la jauge de contrainte telle qu'elle soit suspendue entre la portion d'encastrement et le corps, il est possible de réaliser cette jauge telle que sa section soit la plus réduite possible, ce qui permet d'optimiser la sensibilité de détection de celle-ci. En faisant appel à une jauge de contrainte suspendue, et non implantée dans un élément du capteur, on évite également l'apparition de courants de fuite qui apparaitraient si la jauge de contrainte était réalisée par implantation de dopants dans un élément du capteur, par exemple sur les moyens de liaison.

De plus, étant donné que la mesure du champ magnétique est réalisée par la jauge suspendue, c'est-à-dire un moyen décorrélé de la partie sensible au champ magnétique, à savoir le corps, la structure du capteur peut créer intrinsèquement, en fonction du design de celui-ci, une amplification de contrainte sur la jauge suspendue, améliorant ainsi la sensibilité de la mesure réalisée.

Il est également proposé un capteur de champ magnétique comportant au moins :

- un corps comprenant des moyens magnétiques aptes à former un couple s'exerçant sur le corps sous l'action d'un champ magnétique extérieur à détecter,
- des moyens de liaison reliant mécaniquement le corps à une portion d'encastrement du capteur par au moins une liaison pivot d'axe perpendiculaire à la direction du champ magnétique à détecter,
- des moyens de détection d'une contrainte exercée par le corps sous l'action du couple, comportant au moins une jauge de contrainte suspendue entre la portion d'encastrement et le corps.

La jauge de contrainte suspendue peut être disposée en dehors de l'axe de la liaison pivot et/ou perpendiculairement à l'axe de la liaison pivot.

Ainsi, dans le cas d'un couple d'axe perpendiculaire au plan du corps, la jauge de contrainte peut être de préférence décalée, au moins dans ledit plan du corps, par rapport à l'axe de la liaison pivot. Dans le cas d'un couple d'axe situé dans le plan du corps, la jauge de contrainte peut être de préférence disposée dans au moins dans un plan perpendiculaire à celui du corps et décalée par rapport à l'axe de la liaison pivot.

Les moyens magnétiques peuvent comporter un matériau ferromagnétique, de préférence dur, dont la direction d'aimantation est perpendiculaire à la direction du champ magnétique à détecter et à l'axe de la liaison pivot. De tels moyens magnétiques ont notamment pour avantage de fonctionner sans électricité, participant ainsi à réduire la consommation électrique du capteur.

Le matériau ferromagnétique peut par exemple être du CoPt, ou du NdFeB, ou encore du SmCo. Ces matériaux ont notamment pour avantage de présenter une forte coercivité, par exemple supérieure à environ 0,1 T, ce qui implique qu'ils n'ont pas besoin d'être ré-aimantés durant la vie du capteur, contrairement aux couches magnétiques présentes dans les capteurs de type AMR de l'art antérieur.

Dans une variante, le matériau ferromagnétique peut être un matériau ferromagnétique doux, c'est-à-dire présentant une faible coercivité, par exemple inférieure ou égale à environ 1 mT, et par exemple à base de FeNi ou de CoFe. L'aimantation d'un matériau ferromagnétique doux varie en fonction du champ magnétique extérieur, en particulier en fonction du champ magnétique à mesurer. Ainsi, lorsque les moyens magnétiques comportent un matériau ferromagnétique doux, le corps comprenant les moyens magnétiques peut avoir une forme allongée dans une direction orthogonale à la direction du champ magnétique à mesurer, induisant une anisotropie dite « de forme » dans ladite direction orthogonale à la direction du champ magnétique à mesurer. Le rapport longueur/largeur de cette forme allongée peut être supérieur ou égal à 5. De plus, étant donné que la mesure d'un champ magnétique à partir d'un matériau ferromagnétique doux est non-linéaire, il est possible de minimiser cette non-linéarité en maximisant le champ d'anisotropie de forme (qui dépendra de la forme et des propriétés du matériau magnétique) de sorte qu'il soit très grand, par exemple d'un rapport supérieur ou égal à 100, par rapport aux champs à mesurer.

Pour minimiser la non-linéarité de la mesure d'un champ magnétique réalisée à partir d'un matériau ferromagnétique doux, il est également possible, lorsque les moyens magnétiques comportent un matériau ferromagnétique doux, que le capteur puisse comporter également des moyens d'aimantation dudit matériau ferromagnétique aptes à aimanter le matériau ferromagnétique doux par un champ magnétique de polarisation qui peut être fixe ou variable, et tels que le matériau ferromagnétique et ces moyens d'aimantation soient destinés à former un électroaimant. Ces moyens d'aimantation peuvent comporter au moins une bobine destinée à être parcourue par un courant constant ou variable, cette bobine pouvant être intégrée à la structure et positionnée sur le corps du capteur, ou être par exemple extérieure aux autres éléments du capteur et de dimensions macroscopiques.

Enfin, il est également possible que le matériau ferromagnétique doux présente des propriétés analogues à un matériau ferromagnétique dur, c'est-à-dire qu'il ait une aimantation ne variant pas en fonction du champ magnétique extérieur, en disposant le matériau ferromagnétique dans un empilement de couches particulier. En effet, les moyens magnétiques peuvent comporter un empilement d'une ou plusieurs couches de matériau ferromagnétique disposées de manière alternée avec une ou plusieurs couches de matériau antiferromagnétique. Dans une telle variante, chaque empilement de couches peut former un ensemble de blocs parallèles et disjoints entre eux. Ces blocs peuvent être de forme parallélépipédique rectangle, chaque bloc pouvant comporter une portion de chaque couche de l'empilement. De plus, lorsque ces blocs sont de forme allongée parallèlement à la direction de l'axe d'aimantation, cela introduit une anisotropie de forme dans une direction orthogonale à la direction du champ magnétique à mesurer.

Dans une autre variante, les moyens magnétiques peuvent comporter au moins une bobine destinée à être traversée par un courant électrique dans un plan permettant de générer un champ magnétique induit de direction perpendiculaire à la direction du champ magnétique à détecter.

Dans les cas où les moyens magnétiques ont leur grandeur sensible au champ à mesurer qui est potentiellement variable de manière maitrisée (par exemple, lorsque les moyens magnétiques comportent au moins un matériau ferromagnétique doux disposé dans un champ de polarisation variable, la grandeur sensible correspondant dans ce cas à l'aimantation du matériau ferromagnétique, ou lorsque les moyens magnétiques comportent au moins une bobine destinée à être parcourue par un courant variable, la grandeur sensible correspondant dans ce cas au courant de la bobine), il est possible de faire varier cette grandeur sensible à une fréquence sensiblement proche d'une fréquence de résonance mécanique du corps du capteur, permettant de faire entrer en résonance le corps du capteur et amplifier la force s'exerçant sur les moyens de détection du capteur par le facteur de qualité du résonateur mécanique ainsi formé (qui peut être supérieur à 100000). Ainsi, il est possible de démultiplier la sensibilité du capteur par ce facteur de qualité.

Le corps peut comporter un caisson dans lequel sont disposés les moyens magnétiques ou une face sur laquelle sont disposés les moyens magnétiques.

Ainsi, le corps peut comporter un caisson dans lequel le ou les matériaux ferromagnétiques sont disposés ou une face sur laquelle est disposée la bobine.

Les moyens de liaison peuvent comporter au moins une charnière. De préférence, cette charnière peut avoir une épaisseur inférieure ou égale à celle du corps.

Le corps peut être de forme sensiblement parallélépipédique rectangle. Le corps peut comporter deux faces principales parallèles, ou en regard, l'une par rapport à l'autre, la charnière pouvant être reliée à une autre face du corps sensiblement perpendiculaire aux deux faces principales du corps.

La jauge de contrainte suspendue peut être de type piézorésistif et comporter au moins une poutre, par exemple droite, à base d'un matériau semi-conducteur ou au moins une poutre à base d'un matériau métallique, par exemple pliée en forme de U, de grecque, ou encore de serpentin.

En mettant en oeuvre une détection de type piézorésistif, le capteur peut fonctionner à pression ambiante et ne nécessite donc pas d'encapsulation.

Les moyens de détection peuvent comporter en outre des moyens de mesure de la résistance électrique de la jauge de contrainte suspendue.

La jauge de contrainte suspendue peut être de type résonateur et comporter au moins une poutre vibrante, les moyens de détection pouvant comporter en outre des moyens d'excitation de la poutre vibrante et des moyens de mesure d'une variation de la fréquence de vibration de la poutre. Ainsi, en réalisant une telle détection, mettant en oeuvre par exemple une détection capacitive de la fréquence de résonance de la poutre vibrante, la consommation électrique du capteur reste faible. On entend par poutre vibrante aussi bien une poutre de forme sensiblement longitudinale qu'une poutre d'une toute autre forme, par exemple en forme de diapason.

Les moyens d'excitation de la poutre vibrante peuvent comporter au moins un générateur de tension à composantes continue et/ou alternative relié électriquement à au moins une électrode d'excitation couplée à la poutre vibrante, et les moyens de mesure d'une variation de la fréquence de vibration de la poutre peuvent comporter au moins des moyens de mesure d'une variation de fréquence du potentiel électrique d'au moins une électrode de détection couplée à la poutre vibrante. Les moyens de mesure de la variation de la fréquence de vibration peuvent être des moyens piézorésistifs.

Dans une variante, le capteur peut comporter en outre au moins une seconde jauge de contrainte suspendue entre la portion d'encastrement et le corps, les deux jauges de contrainte suspendues pouvant être disposées de part et d'autre de l'axe de la liaison pivot. Cette variante permet notamment de réaliser une détection différentielle de champ magnétique et d'obtenir ainsi une meilleure précision de mesure du champ magnétique. De préférence, les jauges de contrainte peuvent être disposées de manière symétrique par rapport à l'axe de la liaison pivot.

Le capteur peut comporter au moins une jauge de contrainte suspendue entre la portion d'encastrement et le corps montée en point de Wheatstone. Lorsque le capteur comporte plusieurs jauges de contrainte suspendues, une ou plusieurs de ces jauge de contrainte peuvent être montées en pont de Wheatstone. Dans le cas où une seule jauge de contrainte est montée en pont de Wheatstone, les autres résistances du pont de Wheatstone peuvent être des résistances de référence.

Dans une autre variante, le capteur peut comporter en outre :

- un second corps comprenant des seconds moyens magnétiques aptes à former un second couple s'exerçant sur le second corps sous l'action du champ magnétique à détecter de manière sensiblement similaire au premier corps,
- des seconds moyens de liaison reliant mécaniquement le second corps à une portion d'encastrement du capteur par au moins une liaison pivot d'axe perpendiculaire à la direction du champ magnétique à détecter,
- des seconds moyens de détection d'une contrainte exercée par le second corps sous l'action du second couple, comportant au moins une seconde jauge de contrainte suspendue entre la portion d'encastrement et le second corps et destinée à travailler de manière différentielle en compression ou tension par rapport à la première jauge de contrainte suspendue travaillant respectivement en tension ou en compression.

Ce montage différentiel permet, de part la détection différentielle réalisée par le capteur, de décorréler un signal (en compression ou en tension) provenant d'une accélération d'un signal provenant d'un couple exercée sur les corps sous l'action d'un champ magnétique extérieur.

Dans une autre variante, le corps du capteur, par exemple de forme sensiblement parallélépipédique rectangle, peut comporter deux faces principales parallèles, ou en regard, l'une par rapport à l'autre, et par exemple de forme sensiblement carrée, et comporter un évidement traversant les deux faces principales, les sections dans les plans passant par les deux faces principales pouvant par exemple avoir une forme sensiblement carrée, l'évidement pouvant être centré par rapport aux sections des deux faces principales. Dans ce cas, le capteur peut comporter en outre :

- au moins deux moyens de liaison pouvant chacun relier mécaniquement une paroi du corps, chaque paroi pouvant être perpendiculaire aux deux faces principales du corps et former un côté de l'évidement, à la portion d'encastrement du capteur disposée dans l'évidement par une liaison pivot d'axe perpendiculaire à la direction du champ magnétique à détecter et perpendiculaire aux deux faces principales du corps,
- au moins une jauge de contrainte piézorésistive suspendue entre la portion d'encastrement du capteur et le corps.

Lorsqu'un tel capteur comporte plusieurs jauges de contrainte suspendues, celles-ci peuvent être disposées deux à deux de part et d'autre de chacun des axes des liaisons pivots des moyens de liaison.

Ces variantes de réalisation ont pour avantage de réaliser des mesures différentielles de champ magnétique. Ainsi, ces capteurs ne sont pas ou peu sensibles aux accélérations que peuvent subir les capteurs durant une mesure de champ magnétique.

Dans une autre variante, le corps peut avoir une forme telle que le centre de gravité du corps soit sensiblement proche, ou au niveau, de l'axe de la liaison pivot. Ainsi, le corps forme une masse sensiblement équilibrée autour de l'axe de la liaison pivot. Cette variante permet de minimiser la sensibilité du capteur aux accélérations durant une mesure de champ magnétique.

Le centre de gravité des moyens magnétiques peut être sensiblement proche de l'axe de la liaison pivot.

Le capteur peut être de type MEMS et/ou NEMS.

Avantageusement, le capteur peut être réalisé à partir d'un substrat SOI. En réalisant ce capteur en technologie planaire, par exemple dans un substrat SOI, il est possible de le co-intégrer avec par exemple un accéléromètre tri-axes pouvant être réalisé de manière analogue, par exemple à partir du même substrat, ou encore de réaliser avec cette technologie un capteur différentiel pour remonter directement à la mesure d'une accélération. On peut ainsi réaliser des centrales d'altitude permettant de réaliser à la fois une orientation et une mesure de déplacements. De plus, ce capteur peut former une structure MEMS et/ou NEMS ne nécessitant aucun assemblage, ce qui permet de réduire son coût de réalisation et d'accroître la robustesse et la compacité du capteur.

L'invention concerne également un capteur de champ magnétique à deux ou trois directions comportant respectivement deux ou trois capteurs magnétiques tel que décrits précédemment, les capteurs magnétiques étant disposés tels que les directions des champs magnétiques destinées à être mesurées par ces capteurs soient perpendiculaires les unes par rapport aux autres. On peut ainsi mesurer, grâce à plusieurs capteurs mono-axe co-intégrés, les composantes d'un champ magnétique selon 2 ou 3 axes, y compris l'axe perpendiculaire au plan du capteur.

Lorsque ce capteur est un capteur de champ magnétique à trois directions, les axes des liaisons pivot de deux des capteurs magnétiques peuvent être perpendiculaires par rapport à l'axe de la liaison pivot du troisième capteur magnétique.

Chaque capteur magnétique peut comporter au moins un matériau ferromagnétique dont la direction d'aimantation peut être perpendiculaire à la direction de la composante du champ magnétique à détecter par ledit capteur et perpendiculaire à l'axe de la liaison pivot dudit capteur.

Dans une variante, chaque capteur magnétique peut comporter au moins un matériau ferromagnétique dont la direction d'aimantation est perpendiculaire à l'axe de la liaison pivot dudit capteur, les directions d'aimantation des matériaux ferromagnétiques des trois capteurs magnétiques pouvant être similaires, et pouvant comporter en outre au moins un guide de flux magnétique apte à réorienter des lignes de champ magnétique selon une première direction perpendiculaire à la direction initiale desdites lignes de champ, ledit guide de flux magnétique pouvant être couplé à l'un des trois capteurs magnétiques tel que ce capteur puisse mesurer le champ magnétique formé par lesdites lignes de champ réorientées.

Le capteur peut comporter en outre au moins un quatrième capteur magnétique similaire au capteur auquel est couplé le guide de flux magnétique, ledit guide de flux magnétique pouvant être apte à réorienter des lignes de champ magnétique selon une seconde direction perpendiculaire à la direction initiale desdites lignes de champ et opposée à la première direction de réorientation des lignes de champ, le guide de flux magnétique pouvant être en outre couplé au quatrième capteur magnétique tel que ce quatrième capteur puisse mesurer le champ magnétique formé par lesdites lignes de champ réorientées selon la seconde direction.

Le guide de flux magnétique peut comporter au moins un élément d'amplification de lignes de champ magnétique.

De manière générale, on peut ajuster la gamme de mesure du champ magnétique à détecter en modifiant certains paramètres des moyens magnétiques (par exemple le volume du matériau magnétique et/ou la nature du matériau magnétique) et/ou en modifiant la taille de la jauge de contrainte et/ou son positionnement.

L'invention concerne également un procédé de réalisation d'un capteur de champ magnétique comportant au moins les étapes de :

- réalisation d'un corps comprenant des moyens magnétiques aptes à former un couple s'exerçant sur le corps sous l'action d'un champ magnétique extérieur à détecter,
- réalisation de moyens de liaison, distincts du corps, reliant mécaniquement le corps à une portion d'encastrement du capteur par au moins une liaison pivot d'axe perpendiculaire à la direction du champ magnétique à détecter,
- réalisation de moyens de détection d'une contrainte exercée par le corps sous l'action du couple, distincts des moyens de liaison, comportant au moins une jauge de contrainte suspendue dont au moins une première partie est reliée mécaniquement à la portion d'encastrement, au moins une deuxième partie étant reliée mécaniquement au corps, et dont au moins une troisième partie disposée entre la première et la deuxième partie est suspendue entre la portion d'encastrement et le corps.

## BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :

- les figures 1A, 1B, 2A et 2B représentent des vues de dessus et de profil de capteurs de champ magnétique, objets de la présente invention, selon un premier et un deuxième mode de réalisation,
- les figures 3 et 4 représentent des vues de dessus d'un capteur de champ magnétique, objet de la présente invention, selon des variantes du deuxième mode de réalisation,
- les figures 5A, 5B, 6A et 6B représentent des vues de dessus et de profil de capteurs de champ magnétique, objets de la présente invention, selon un troisième et un quatrième mode de réalisation,
- la figure 7 représente une vue de dessus d'un capteur de champ magnétique, objet de la présente invention, selon un cinquième mode de réalisation,
- la figure 8 représente une vue de dessus d'un capteur de champ magnétique à trois dimensions, objet de la présente invention, selon un mode de réalisation particulier,
- les figures 9A et 9B représente des variantes de réalisation des éléments d'un capteur de champ magnétique à trois dimensions, objet de la présente invention,
- les figures 10A et 10B représentent des exemples d'empilements de couches de matériaux ferromagnétique et antiferromagnétique de capteurs de champ magnétique, objets de la présente invention,

- les figures 11A et 11B représentent des variantes de réalisation d'un capteur de champ magnétique à trois dimensions, objet de la présente invention,
- les figures 12A et 12B représentent de manière schématique des exemples de corps équilibrés de capteurs de champ magnétique, objets de la présente invention, selon des modes de réalisation particuliers,
- les figures 13A à 13J et 14A à 14H représentent des étapes de procédés de réalisation d'un capteur de champ magnétique, objet de la présente invention, selon des modes de réalisations particuliers.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les axes représentés sur les différentes figures décrites ci-dessous et portant la même référence sont similaires d'une figure à l'autre.

Les différentes possibilités (variantes et modes de réalisation) doivent être comprises comme n'étant pas exclusives les unes des autres et peuvent se combiner entre elles.

## EXPOSÉ DÉTAILLÉ DE MODES DE RÉALISATION PARTICULIERS

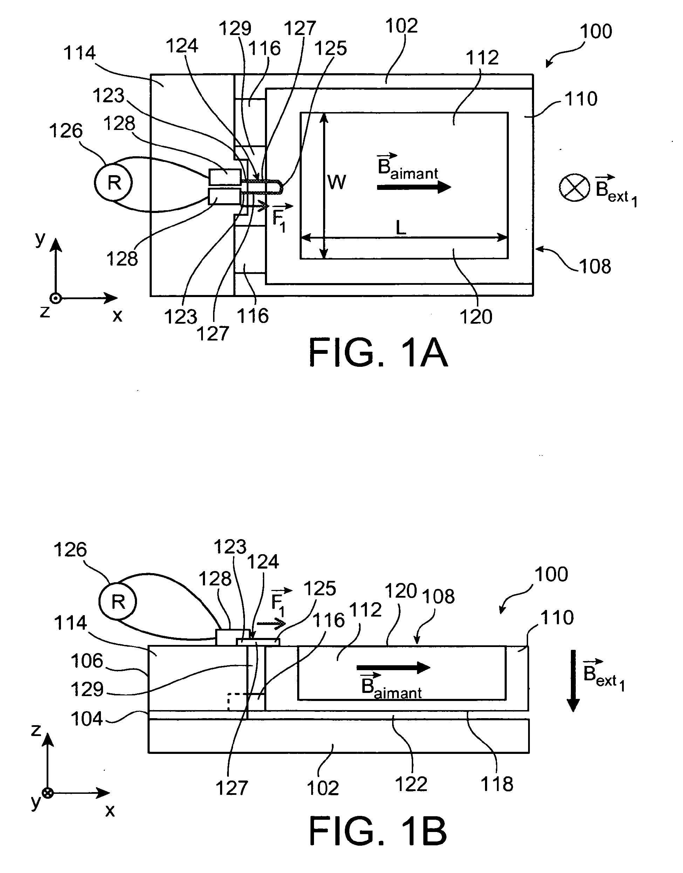

Un exemple de capteur de champ magnétique 100 selon un premier mode de réalisation va être décrit en liaison avec les figures 1A et 1B, qui représentent respectivement une vue de dessus et une vue de profil du capteur 100.

Le capteur 100 est réalisé à partir d'un substrat SOI comportant un empilement formé par une couche support 102 à base de semi-conducteur, une couche diélectrique 104 et une couche superficielle 106 également à base de semi-conducteur. Le semi-conducteur des couches 102 et 106 est par exemple du silicium monocristallin ou polycristallin. La couche superficielle 106 pourrait également être à base de SiGe ou de tout autre matériau de type III-V. La couche diélectrique 104 est par exemple à base de $SiO_2$. Dans une variante, le capteur 100 pourrait être réalisé à partir d'un autre type de substrat (bulk, semi-conducteur sur verre, ...).

Le capteur 100 comporte un corps 108 formant une partie mobile du capteur 100 et comprenant des moyens magnétiques aptes à déplacer le corps 108 sous l'action d'un champ magnétique. Dans ce premier mode de réalisation, le corps 108 comporte un caisson 110 formé dans la couche superficielle 106 et dans lequel est disposé un matériau ferromagnétique 112 formant un aimant permanent et présentant une direction d'aimantation permanente $B_{aimant}$ (représentée par une flèche parallèle à l'axe x sur les figures 1A et 1B) perpendiculaire à la direction d'un champ magnétique externe $B_{ext1}$ (représentée également par une flèche sur les figure 1A et 1B) que le capteur 100 est destiné détecter. Le matériau ferromagnétique 112 est par exemple à base de CoPt, ou de NdFeB ou de SmCo.

Dans une variante, le matériau ferromagnétique 112 peut être un matériau ferromagnétique doux présentant une faible coercivité, par exemple du FeNi ou du CoFe. Dans cette variante, il est également possible que le capteur 100 comporte des moyens d'aimantation aptes à aimanter le matériau ferromagnétique 112 et former ainsi un électroaimant. Ces moyens d'aimantation peuvent comporter une bobine, disposée sur le corps 108 ou à côté du capteur 100, destinée à être parcourue par un courant variable ou constant.

Dans ce premier mode de réalisation, le corps 108 a une forme de parallélépipède rectangle dont une première face principale 118, appelée face inférieure, est comprise dans un plan passant par la face de la couche superficielle 106 en contact avec la couche diélectrique 104, et parallèle au plan (X,Y), et une seconde face principale 120, opposée à la face inférieure 118, appelée face supérieure. Les faces inférieure 118 et supérieure 120 sont parallèles à un plan appelé plan du capteur 100, lui-même parallèle au plan (X,Y). De plus, le matériau ferromagnétique 112 forme également un bloc parallélépipédique rectangle. Dans ce premier mode de réalisation, le capteur 100 est destiné à détecter un champ magnétique $B_{ext1}$ comportant une unique composante perpendiculaire au plan du capteur 100.

Le corps 108 a par exemple des dimensions selon les axes X et Y comprises entre environ quelques micromètres, par exemple 20 $\mu$m, et 1 mm, et une épaisseur (dimension selon l'axe Z) égale à environ 1 $\mu$m, ou comprise entre environ 0,1 $\mu$m et 10 $\mu$m, voir quelques dizaines de micromètres. Le bloc formé par le matériau ferromagnétique 112 a une largeur W (dimension selon l'axe y) pouvant être comprise entre quelques micromètres et 500 $\mu$m, par exemple égale à environ 10 $\mu$m, et une longueur L (dimension selon l'axe x) pouvant être comprise entre environ 20 $\mu$m et 500 $\mu$m, et par exemple égale à environ 100 $\mu$m. Le rapport d'aspect L/W du bloc formé par le matériau ferromagnétique 112 peut être important et par exemple égal ou supérieur à environ 5, notamment lorsque le matériau ferromagnétique 112 est un matériau ferromagnétique doux.

Le corps 108, et plus précisément le caisson 110, est relié à une partie fixe du capteur 100, ou portion d'encastrement 114, formée par une portion de la couche superficielle 106, par deux charnières 116. Les charnières 116 sont des portions de silicium gravées dans la couche superficielle 106, qui ont une forme de parallélépipède rectangle et qui ont une épaisseur (dimension selon l'axe Z) comprise entre environ quelques nanomètres, ou quelques dizaines de nanomètres, et quelques micromètres, par exemple entre environ 50 nm et 500 nm. Les charnières 116 forment une liaison pivot d'axe parallèle à l'axe Y entre la portion d'encastrement 114 et le caisson 110. Chacune des charnières 116 est reliée à une extrémité d'un même côté du caisson 110 perpendiculaire aux faces principales 118 et 120. Sur l'exemple des figures 1A et 1B, les charnières 116 sont disposées dans le prolongement du plan dans lequel se trouve la face inférieure 118 du corps 108. Dans une variante, ces charnières 116 peuvent être reliées à une hauteur différente du corps 108, par exemple dans le prolongement du plan dans lequel se trouve la face supérieure 120 du corps 108.

Le capteur 100 comporte un espace vide 122 formé entre le corps 108 et la couche support 102, ainsi qu'entre les charnières 116 et la couche support 102. Cet espace vide 122 correspond à l'espace occupé par une portion de la couche diélectrique 104 qui a été supprimée au cours de la réalisation du capteur 100. Ainsi, au repos, c'est-à-dire lorsque le corps 108 n'est pas sollicité par un champ magnétique extérieur ($B_{ext1}$ = 0), les charnières 116 réalisent un soutien mécanique du corps 108, maintenant celui-ci dans un plan parallèle au plan du capteur 100.

Le capteur 100 comporte également des moyens 124 permettant de détecter un déplacement du corps 108 sous l'action d'un champ magnétique extérieur $B_{ext1}$ dirigé perpendiculairement à la direction d'aimantation permanente $B_{aimant}$ et perpendiculairement au plan du capteur 100. Un tel champ magnétique $B_{ext1}$ tend à faire subir à la masse magnétique 112, et donc au corps 108, une rotation autour de l'axe de la liaison pivot formée par les charnières 116 entre la portion d'encastrement 114 et le corps 108. Sur l'exemple des figures 1A et 1B, cet axe est parallèle à l'axe Y (et donc perpendiculaire à $B_{aimant}$ et à $B_{ext1}$) et passe par la jonction entre les charnières 116 et la portion d'encastrement 114, au niveau du milieu de l'épaisseur des charnières 116. De plus, étant donné que les charnières 116 sont solidaires au voisinage des deux extrémités d'un même côté du corps 108, celles-ci empêchent d'éventuelles forces extérieures, par exemple dues à des accélérations subies par le capteur 100 et orientées dans le plan du capteur 100, de mettre en rotation le corps 108 dans le plan du capteur 100, c'est-à-dire empêchant les rotations du corps 108 selon des axes parallèles aux axes Z et X.

Les moyens de détection 124 sont ici une jauge de contrainte suspendue entre la portion d'encastrement 114 et la face supérieure 120 du corps 108. Cette jauge de contrainte 124 est disposée dans un plan qui est sensiblement parallèle au plan du capteur 100. Un espace sépare la jauge de contrainte 124 des charnières 116. De même, dans une variante de réalisation où les charnières seraient réalisées dans le prolongement du plan de la face supérieure 120 du corps 108, la jauge de contrainte 124 pourrait dans ce cas être suspendue entre la face inférieure 118 du corps 108 et la portion d'encastrement 114. De manière générale, les moyens de détection 124 et les charnières 116 ne sont pas disposés dans un même plan parallèle au plan du capteur 100 afin que les moyens de détection 124 puissent détecter un déplacement du corps 108 lorsqu'il est soumis au champ magnétique $B_{ext1}$.

Ainsi, le mouvement de rotation du corps 108 autour de l'axe pivot formé par les charnières 116 se traduit par l'application d'une force exercée sur la jauge de contrainte 124 qui est perpendiculaire au champ magnétique $B_{ext1}$ et qui se trouve dans le plan de rotation du corps 108 (plan parallèle au plan (X,Z)). Sur l'exemple des figures 1A et 1B, cette force, représentée par une flèche et désignée par la référence $F_1$, met la jauge de contrainte 124 en tension étant donné que la rotation du corps 108 est dirigée dans le sens du champ magnétique $B_{ext1}$. Si le champ magnétique $B_{ext1}$ était dirigé dans le sens opposé à celui représenté sur les figures 1A et 1B, la jauge de contrainte 124 serait soumise à une force dirigée dans la direction opposée à la force $F_1$ représentée et qui mettrait la jauge de contrainte 124 en compression.

La structure de ce capteur 100 créé intrinsèquement une amplification des contraintes sur la jauge 124 car la jauge de contrainte suspendue 124, les charnières 116 et le corps 108 forment une structure en bras de levier. Ainsi, plus la distance entre les charnières 116 et la jauge de contrainte 124 est petite, plus la force de compression ou de tension appliquée sur la jauge de contrainte 124, résultante du champ magnétique présent, est grande.

Dans ce premier mode de réalisation du capteur 100, la jauge de contrainte 124 est de type piéorésistif et est formée par une poutre métallique. Cette poutre est ici pliée en forme de « U ». Ainsi, deux extrémités 123 de la poutre 124 sont disposées contre la portion d'encastrement 114 et reliées mécaniquement (par une liaison encastrement) à la portion d'encastrement 114, et une partie 125 sensiblement en forme de demi-cercle, formée par la zone pliée de la poutre 124, de la poutre est disposée contre le corps 108 et reliée mécaniquement (par une liaison encastrement) au corps 108. La jauge de contrainte 124 comporte ici deux parties 127 disposées entre les extrémités 123 et la partie 125 en forme de demi-cercle qui sont suspendues entre la portion d'encastrement 114 et le corps 108 dans un espace vide 129 formé entre le corps 108 et la portion d'encastrement 114 et dans lequel se trouve les deux charnières 116. Compte tenu des dimensions micrométriques ou nanométriques de la poutre 124, celle-ci peut également être appelée micro-poutre ou nano-poutre, ou encore micro-fil ou nano-fil. La poutre 124 a une résistance initiale R, lorsque $B_{ext1}$ est nul, qui varie de +/- $\Delta$R lorsque la poutre 124 est mise en compression ou en tension par un mouvement du corps 108 en présence d'un champ magnétique $B_{ext1}$ non nul, la valeur de $\Delta$R étant proportionnelle à la valeur de $B_{ext1}$. Ainsi, en mesurant la valeur de $\Delta$R, on peut en déduire la valeur de $B_{ext1}$. Dans une variante, la jauge de contrainte piézorésistive 124 pourrait être formée par une poutre à base d'un matériau semi-conducteur, ou plus généralement à base de tout type de matériau présentant des propriétés piézorésistives.

Le capteur 100 comporte des moyens de mesure 126 de la résistance électrique de la jauge de contrainte 124, ici un ohmmètre, reliés à deux contacts électriques 128. Chaque contact électrique 128 est formé par une portion métallique disposée sur la zone d'encastrement 114, chaque contact électrique 128 étant relié à une des deux extrémités de la jauge de contrainte 124, c'est-à-dire à une des deux extrémités de la poutre 124. Il est ainsi possible de mesurer les variations ∆R de la résistance de la jauge de contrainte 124.

Le capteur 100 comporte donc des moyens de mesure de champ magnétique 124 qui sont suspendus entre la portion d'encastrement 114, formant une partie fixe du capteur 100, et le corps 108, formant une partie mobile du capteur 100. Ces moyens de mesure 124 sont donc décorrélés de la structure sensible au champ magnétique, c'est-à-dire le corps 108 comportant l'aimant permanent 112. Le capteur 100 comporte donc trois parties pouvant, compte tenu de la décorrélation entre les moyens de mesure 124 et la partie sensible au champ magnétique 108, être optimisées indépendamment les unes des autres :

- une première partie sensible au champ magnétique et comprenant l'aimant permanent, c'est-à-dire le corps 108,
- une deuxième partie sensible à la contrainte obtenue lorsque la première partie est soumise à un champ magnétique, c'est-à-dire les moyens de détection 124, et
- une troisième partie reliant la première partie à un ancrage ou portion d'encastrement, c'est-à-dire les charnières 116.

Cette optimisation peut par exemple porter sur les épaisseurs (dimensions parallèles à l'axe Z) de chacune de ces parties qui peuvent être choisies indépendamment les unes des autres.

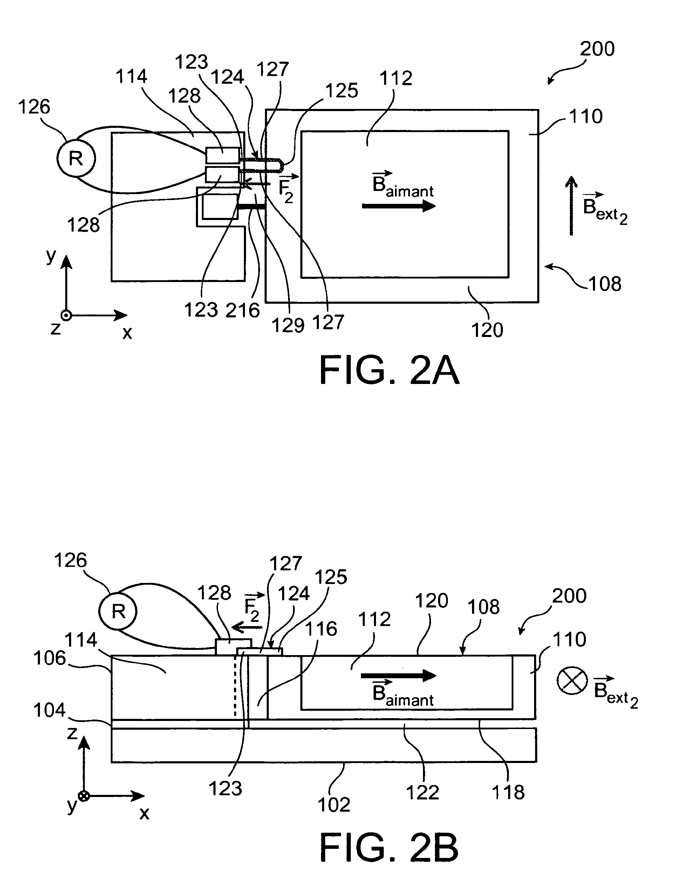

Un exemple de capteur de champ magnétique 200 selon un second mode de réalisation va être décrit en liaison avec les figures 2A et 2B, qui représentent respectivement une vue de dessus et une vue de profil du capteur 200.

De manière analogue au capteur 100 selon le premier mode de réalisation, le capteur 200 est réalisé à partir d'un substrat SOI comportant les couches 102, 104 et 106 (non représentées sur la figure 2A), et comprend le corps 108, la portion d'encastrement 114, la jauge de contrainte 124 et les moyens de mesure 126.

Par rapport au capteur 100, le capteur 200 n'est pas destiné à détecter un champ magnétique perpendiculaire au plan du capteur 200 (similaire au plan du capteur 100 et parallèle au plan (X,Y)) mais un champ magnétique $B_{ext2}$ orienté dans le plan du capteur 200, ici parallèle à l'axe Y, et perpendiculaire à la direction d'aimantation $B_{aimant}$.

Pour réaliser une telle détection, le corps 108 n'est pas relié à la zone d'encastrement 114 par les deux charnières 116, mais par une unique charnière 216 reliée au corps 108 sur toute son épaisseur, sensiblement au milieu d'un côté du corps 108 perpendiculaire aux deux faces principales 118 et 120 du corps 108, et disposée dans l'espace vide 129 séparant le corps 108 de la partie d'encastrement 114. Ce champ magnétique $B_{ext2}$ tend à faire subir au matériau ferromagnétique 112, et donc au corps 108, une rotation autour d'un axe perpendiculaire au plan du capteur 200. Sur l'exemple des figures 2A et 2B, cet axe est parallèle à l'axe Z (et donc perpendiculaire à $B_{aimant}$ et à $B_{ext2}$) et passe par la jonction entre la charnière 216 et la portion d'encastrement 114. La charnière 216 remplie ici le même rôle de maintien mécanique et de liaison pivot du corps 108 vis-à-vis de la portion d'encastrement 114 que les charnières 116 précédemment décrites.

La jauge de contrainte 124 du capteur 200 est réalisée à côté de la charnière 216. Ainsi, en présence du champ magnétique à détecter $B_{ext2}$ représenté sur les figures 2A et 2B (c'est-à-dire comportant une composante parallèle à l'axe Y), la jauge de contrainte 124 est mise en compression par une force $F_2$ telle que représentée sur les figures 2A et 2B, à partir de laquelle il est possible d'en déduire la valeur de $B_{ext2}$ selon le même principe que le capteur 100 (mesure de la variation de la résistance électrique de la jauge de contrainte 124). Si la composante du champ magnétique à détecter est dans le sens opposé à $B_{ext2}$, la jauge de contrainte 124 est alors mise en tension par une force de direction opposée à la force $F_2$.

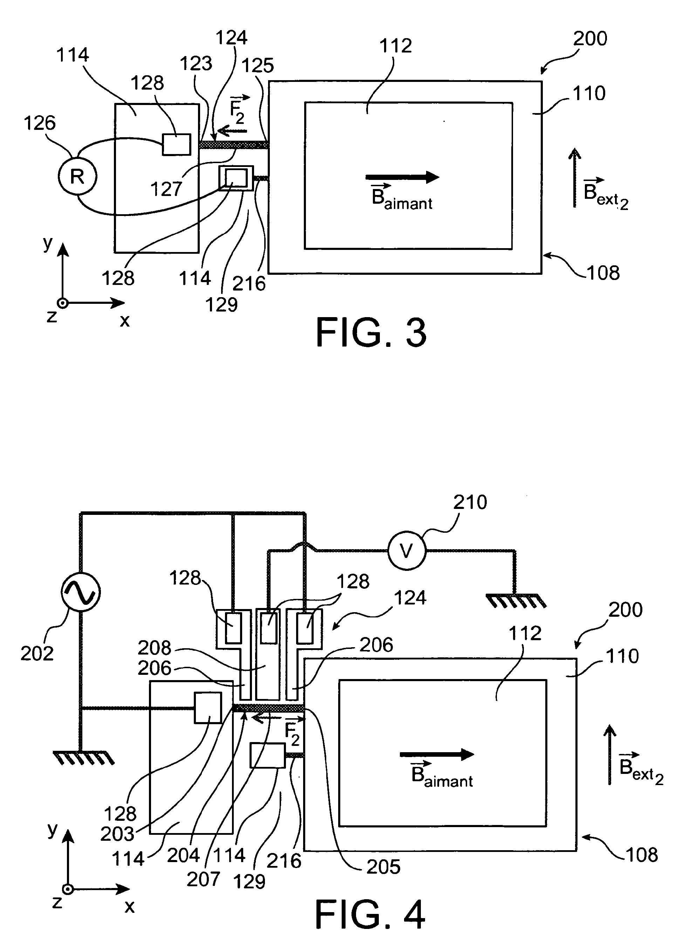

La figure 3 représente une vue de dessus du capteur 200 dans une première variante du second mode de réalisation. Dans cette variante, les moyens de détection 124 ne comportent par une jauge de contrainte piézorésistive formée par une poutre métallique suspendue, mais par une poutre de semi-conducteur suspendue. Ici, cette poutre est à base de silicium et est formée par gravure d'une portion de la couche superficielle du substrat SOI à partir duquel est réalisé le capteur 200.

Par rapport à la poutre suspendue métallique en forme de « U », la poutre de silicium 124 est ici sensiblement droite, et comporte une première extrémité 123 reliée mécaniquement (par une liaison encastrement) à la portion d'encastrement 114, une seconde extrémité 125 reliée mécaniquement (par une liaison encastrement) au caisson 110 du corps 108, et une partie centrale 127 qui se retrouve suspendue dans l'espace vide 129 formé entre le corps 108 et la portion d'encastrement 114. Etant donné que la poutre est réalisée à partir du même matériau que le caisson 110 et la portion d'encastrement 114, un des contacts électriques 128 est ici formé sur une première partie de la portion d'encastrement 114 proche de la première extrémité libre de la poutre 124 et un second contact électrique 128 est formé sur une partie de la portion d'encastrement 114 à laquelle est reliée la charnière 216. En reliant l'ohmmètre 126 entre les contacts électriques 128, on mesure la résistance et la variation de la résistance de la poutre de silicium 124, mais également la résistance du silicium de la portion d'encastrement 114 et du caisson 110 se trouvant entre les extrémités 123, 125 de la poutre 124 et les contacts électriques 128. Etant donné que la résistance électrique du silicium de la portion d'encastrement 114 et du caisson 110 entre les extrémités 123, 125 de la poutre 124 ne varie pas, la variation de résistance mesurée correspond bien à la variation de la résistance électrique de la poutre 124 suspendue.

Cette variante a notamment pour avantage de ne pas imposer de contraintes sur les emplacements des contacts électriques 128 dans le capteur magnétique. Ainsi, les contacts électriques 128 peuvent être disposés à des endroits différents des extrémités de la poutre 124. De plus, cette variante permet en outre d'avoir un très grand effet piézorésistif dans la poutre 124, notamment lorsque celle-ci comporte une section dont les dimensions sont sensiblement nanométriques.

La figure 4 représente une vue de dessus du capteur 200 dans une seconde variante du second mode de réalisation. Dans cette seconde variante, les moyens de détection 124 ne comportent pas de jauge de contrainte piézorésistive mais un résonateur 204, pouvant également être appelé lame vibrante ou poutre vibrante, par exemple réalisé par gravure dans la couche superficielle 106, et comportant une première extrémité 203 reliée mécaniquement (par une liaison encastrement) à la portion d'encastrement 114, une seconde extrémité 205 reliée mécaniquement (par une liaison encestrement) au corps 108, et une partie centrale 207 suspendue entre la portion d'encastrement 114 et le corps 108, dans l'espace vide 129 formé entre le corps 108 et la portion d'encastrement 114. Les moyens de détection 124 comportent en outre deux électrodes d'excitation 206 destinées à faire vibrer le résonateur 204, ainsi qu'une électrode de détection 208 disposée entre les deux électrodes d'excitation 206 et destinée à détecter une variation de la fréquence de vibration du résonateur 204. Un contact électrique 128 est formé sur chacune des électrodes 206 et 208, ainsi que sur la portion d'encastrement 114. Un générateur de tension 202, délivrant une composante continue et une composante alternative, est relié aux deux contacts électriques 128 formés sur les électrodes d'excitation 206. Enfin, un voltmètre 210 est relié entre le contact électrique 128 disposé sur l'électrode de détection 208 et la masse (la portion d'encastrement 114 étant en outre reliée également à la masse).

Ainsi, lorsque la force $F_2$ est appliquée sur le résonateur 204 en raison du mouvement du corps 108 dû à la présence du champ magnétique $B_{ext2}$, la fréquence de vibration du résonateur 204, égale à la fréquence de la composante alternative de la tension appliquée entre les électrodes d'excitation 206, cette tension étant asservie sur la fréquence de résonance de la poutre par les moyens de mesure de la variation de fréquence, à savoir le voltmètre 210, se trouve donc modifiée. Cette variation de fréquence est détectée par l'électrode de détection 208 et le voltmètre 210. A partir de cette différence de fréquence mesurée, on peut alors en déduire la valeur de $B_{ext2}$.

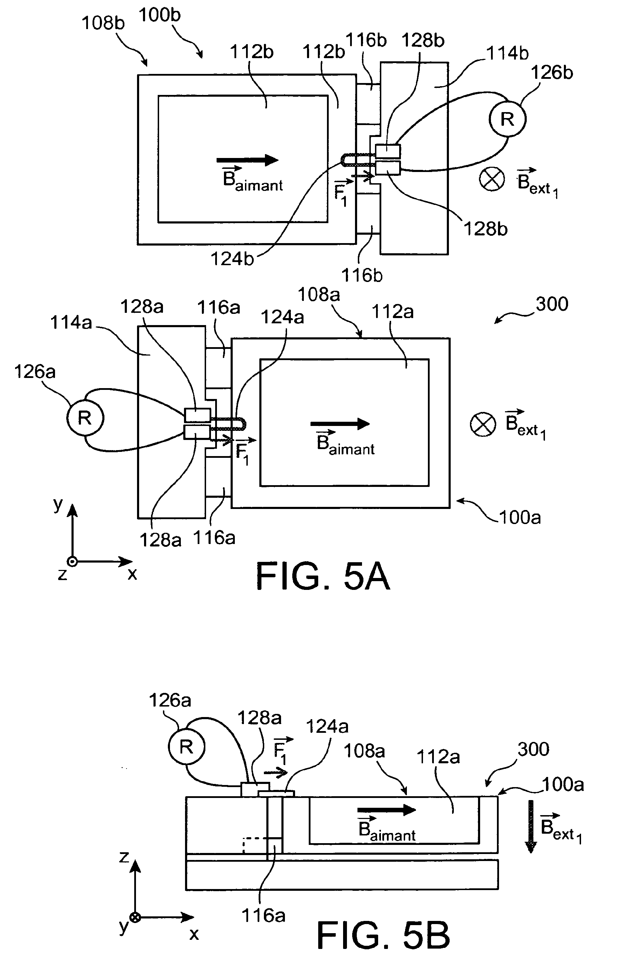

Un exemple de capteur de champ magnétique 300 selon un troisième mode de réalisation va être décrit en liaison avec les figures 5A et 5B, qui représentent respectivement une vue de dessus et une vue de profil du capteur 300.

Ce capteur 300 comporte une première structure de détection 100a similaire au capteur 100 précédemment décrit. De plus, le capteur 300 comporte également une seconde structure de détection 100b comportant les mêmes éléments que la première structure de détection 100a, mais disposés d'une manière différente. Les corps 108a et 108b des deux structures de détection 100a et 100b sont similaires, les matériaux ferromagnétiques 112a et 112b des deux structures 100a, 100b ayant la même direction d'aimantation ($B_{aimant}$) orientée parallèlement à l'axe Z. Par contre, les autres éléments des deux structures de détection 100a et 100b, à savoir les portions d'encastrement 114a, 114b, les charnières 116a, 116b, les moyens de détection 124a, 124b et les contacts électriques 128a, 128b sont disposés de manière axialement symétrique les uns par rapport aux autres selon un axe perpendiculaire au plan (X,Y) qui est parallèle au plan du capteur 300 et aux plans des structures de détection 100a et 100b. Ainsi, en considérant que les charnières 116a sont reliées à un premier côté du corps 108a dans la première structure 100a, les charnières 116b sont reliées, dans la seconde structure de détection 100b, à un second côté du corps 108b opposé à un premier côté du corps 108b correspondant, par analogie de structure, au premier côté du corps 108a.

Ainsi, le capteur 300 permet de réaliser une mesure différentielle d'un champ magnétique. Lorsque les corps 108a, 108b des deux structures de détection 100a, 100b sont soumis à un même champ magnétique, ici $B_{ext1}$, la force $F_1$ créée, qui est similaire en terme d'orientation et de valeur pour les deux structures de détection 100a, 100b compte tenu de la même orientation d'aimantation $B_{aimant}$ des deux matériaux ferromagnétiques 112a, 112b, se traduit par une mise en tension des moyens de détection 124a de la première structure de détection 100a et une mise en compression des moyens de détection 124b de la seconde structure de détection 100b.

Un tel capteur 300 différentiel présente comme avantage de ne pas être sensible aux accélérations parallèles au champ magnétique $B_{ext1}$ destiné à être mesuré car, en présence d'une telle accélération, une compression et une tension supplémentaire est subie, en plus de la force $F_1$ créée par le champ magnétique $B_{ext1}$, par l'un et l'autre des deux moyens de détection 124a, 124b. Cette compression et cette tension supplémentaires étant complémentaires l'une par rapport à l'autre, il est donc possible de déduire, à partir des mesures réalisées par les ohmmètres 126a, 126b, la valeur de $F_1$ en s'affranchissant des effets de l'accélération, et donc de calculer la valeur réelle de $B_{ext1}$.

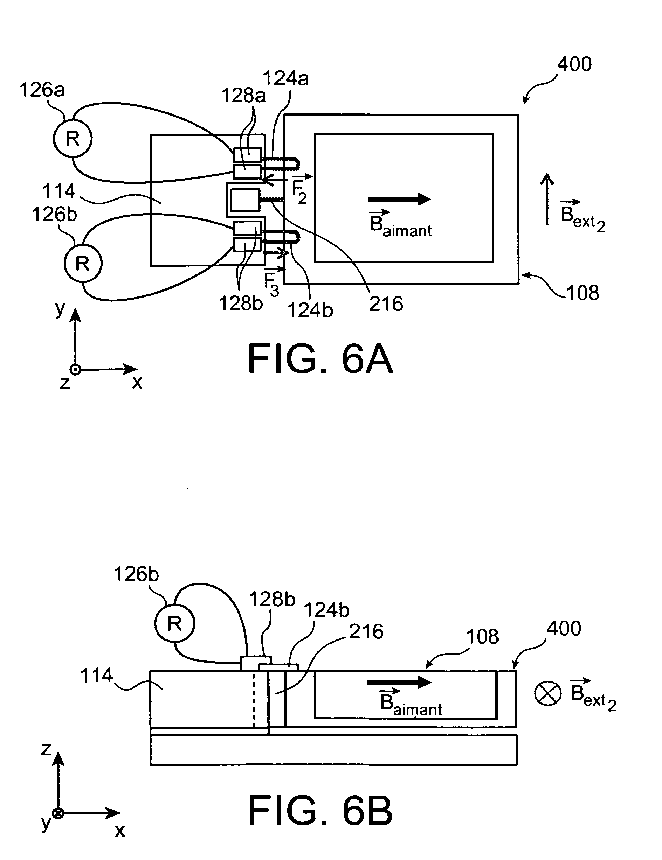

Un exemple de capteur de champ magnétique 400 selon un quatrième mode de réalisation va être décrit en liaison avec les figures 6A et 6B qui représentent respectivement une vue de dessus et une vue de profil du capteur 400.

Par rapport au capteur 200 précédemment décrit, le capteur 400 comporte des premiers moyens de détection 124a, correspondant à la jauge de contrainte 124 du capteur 200, mais également des seconds moyens de détection 124b, par exemple similaires aux premiers moyens de détection 124a. Ces moyens de détection 124a, 124b comportent donc chacun une jauge de contrainte piézorésistive formée par une poutre métallique pliée en forme de « U » et suspendue entre le corps 108 et la portion d'encastrement 114. La charnière 216 est disposée entre les premiers et les seconds moyens de détection 124a, 124b. On voit donc que les jauges de contrainte 124a, 124b sont disposées de part et d'autre de l'axe de rotation du corps 108 se trouvant au niveau de la charnière 216.

Ainsi, de manière analogue au capteur 300, ce capteur 400 forme une structure de mesure différentielle de champ magnétique. Lorsque le corps 108 est soumis au champ magnétique $B_{ext2}$ représenté sur les figures 6A et 6B, le mouvement du corps 108, correspondant à une rotation du corps 108 autour d'un axe perpendiculaire au plan du capteur 400, se traduit par une force $F_2$ de compression appliquée sur les premiers moyens de détection 124a, et une forcé $F_3$ de tension appliquée sur les seconds moyens de détection 124b.

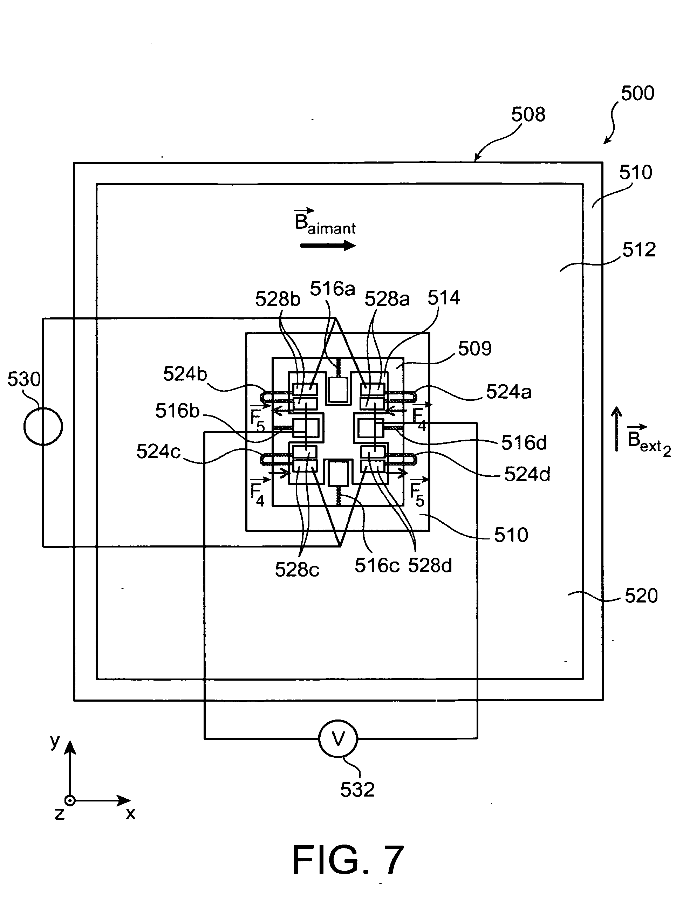

Un exemple de capteur de champ magnétique 500 selon un cinquième mode de réalisation va être décrit en liaison avec la figure 7 qui représente une vue de dessus du capteur 500.

De manière analogue aux capteurs 100, 200, 300 et 400 précédemment décrits, le capteur 500 est réalisé à partir d'un substrat SOI comportant un empilement formé par une couche support 102 à base de semi-conducteur, couche diélectrique 104 et une couche superficielle 106 également à base de semi-conducteur. Le capteur 500 comporte un corps 508 comprenant des moyens magnétiques. Dans ce cinquième mode de réalisation, le corps 508 comporte un caisson 510 formé dans la couche superficielle du substrat SOI et dans lequel est disposé un matériau ferromagnétique 512 formant un aimant permanent présentant une direction d'aimantation permanente $B_{aimant}$ perpendiculaire à la direction d'un champ magnétique externe $B_{ext2}$ que le capteur 500 est destiné détecter. Le matériau ferromagnétique 512 est par exemple de nature similaire au matériau ferromagnétique 112 précédemment décrit.

Dans ce cinquième mode de réalisation, le corps 508 a une forme de parallélépipède rectangle dont une première face principale, appelée face inférieure et non visible sur la figure 7, est comprise dans un plan passant par la face de la couche superficielle en contact avec la couche diélectrique, et parallèle au plan (X,Y), et une seconde face principale 520, opposée à la face inférieure, appelée face supérieure. Les faces inférieure et supérieure 520 sont parallèles à un plan appelé plan du capteur 500 (parallèle au plan (X,Y)). Le corps 508 comporte en outre un évidement 509 dont la section dans un plan parallèle au plan (X, Y) a une forme sensiblement carrée. Une paroi intérieure du caisson 510 forme le contour de l'évidement 509, et une paroi extérieure du caisson 510 forme le contour extérieur du corps 508.

Le corps 508 est relié à une partie fixe du capteur 500 appelée portion d'encastrement 514 et formée notamment par une portion de la couche superficielle disposée dans l'évidement 509. La liaison entre le corps 508 et la portion d'encastrement 514 est réalisée par quatre charnières 516a à 516d, par exemple similaires à la charnière 216 précédemment décrite en liaison avec les capteurs 200 et 400. La portion d'encastrement 514 ayant une section de forme sensiblement carrée dans un plan parallèle au plan (X,Y), chacune des charnières 516a - 516d relie un côté de la zone d'encastrement 514 à un côté de la paroi intérieure du caisson 510, au niveau de l'évidement 509.

Le capteur 500 comporte également des moyens de détection comprenant quatre jauges de contrainte piézorésistives 524a à 524d, chacune formée par une poutre métallique pliée en forme de « U » et suspendue entre un côté du caisson 510, au niveau de sa paroi intérieure délimitant l'évidement 509, et quatre coins de la portion d'encastrement 514. Les quatre jauges de contrainte piézorésistives 524a - 524d s'étendent perpendiculairement à la direction du champ magnétique à détecter $B_{ext2}$, dans le plan (X,Y).

Le champ magnétique $B_{ext2}$ tend à faire subir au matériau ferromagnétique 512, et donc au corps 508, une rotation autour d'un axe parallèle à l'axe Z, c'est-à-dire perpendiculaire au plan du capteur 500, et dont la position dans le plan du capteur 500 correspond sensiblement au centre de la portion d'encastrement 514.

Ainsi, il en résulte que le mouvement de rotation du corps 508 autour de la portion d'encastrement 514 se traduit par l'application d'une force $F_4$ de compression exercée sur deux des moyens de détection 524a, 524c se trouvant au niveau de deux coins opposés de la portion d'encastrement 514 et une force $F_5$ de tension exercée sur les deux autres moyens de détection 524b, 524d se trouvant au niveau des deux autres coins opposés de la portion d'encastrement 514, ces deux forces $F_4$ et $F_5$ étant perpendiculaires au champ magnétique $B_{ext2}$ et se trouvant dans le plan du capteur 500. Dans l'hypothèse où le champ magnétique à détecter est orienté dans la direction opposée à celle de $B_{ext2}$, la force de compression $F_4$ serait appliquée sur les moyens de détection 524b, 524d et la force de tension $F_5$ serait appliquée sur les moyens de détection 524a, 524c.

Les deux extrémités de chacune des jauges de contrainte piézorésistives 524a - 524d sont reliées à une paire de contacts électriques 528a - 528d formés sur la portion d'encastrement 514. Dans ce cinquième mode de réalisation, un des contacts électriques de chacune des quatre jauges de contrainte piézorésistives 524a - 524d est relié à un générateur de tension $V_1$ 530, les quatre autres contacts électriques étant reliés à un voltmètre 532 mesurant une tension $V_2$, formant ainsi un pont de Wheatstone. Au niveau des jauges de contrainte piézorésistives 524a et 524c subissant la force de compression $F_4$, on a donc une variation de résistance $-\Delta R$, et au niveau des jauges de contrainte piézorésistives 524b et 524d subissant la force de tension $F_5$, on a donc une variation de résistance $+\Delta R$. En considérant que les quatre jauges de contrainte 524a - 524d ont chacune une résistance initiale R similaire les unes aux autres, on a donc :

$$dV_2 = \frac{V_1 \left( 2 \times 4 \times dR \times R^3 - \left( -2 \times 4 \times dR \times R^3 \right) \right)}{\left( 4 \times dR \times R^2 \right) \left( 4 \times dR \times R^2 \right)} = V_1 \frac{dR}{R}$$

Soit :

$$\Delta R = \frac{V_2 \times R}{V_1}$$

On déduit alors de la valeur de $\Delta$R la valeur de $B_{ext2}$.

On donne ci-dessous, à titre d'exemples, des valeurs théoriques de caractéristiques obtenues avec le capteur 200 précédemment décrit et comportant un corps 108 dont les dimensions dans le plan (X,Y), correspondant aux parois extérieure du caisson 110, sont égales à environ 100 $\mu$m, et dont l'épaisseur (dimension selon l'axe Z) est égale à environ 1 $\mu$m. La jauge de contrainte 124 de ce capteur 200 est ici un nanofil de silicium monté en pont de Wheatstone avec trois résistances de référence selon le principe précédemment décrit pour le capteur 500, et de hauteur égale à environ 500 nm, de largeur égale à environ 100 nm et de longueur égale à environ 1 $\mu$m :

```
Sensibilité = 21 V/V/T
```

Densité de bruit (à 1kHz, avec une tension Vbridge de 5V) = 8 nV/Hz$^{0,5}$

Résolution (pour une bande passante de 50 Hz et une tension Vbridge, c'est-à-dire la tension aux bornes du pont de Wheatstone, de 5V) = 4,2.10$^{-10}$ T

Full Scale (domaine de mesure) = 9.10$^{-4}$ T

Les capteurs de champ magnétique 100 à 500 précédemment décrits réalisent une mesure d'un champ magnétique selon un axe donné, c'est-à-dire des champs magnétiques comportant une unique composante selon un axe. Il est également possible de réaliser des capteurs réalisant une mesure d'un champ magnétique comportant des composantes selon 2 axes perpendiculaires l'un par rapport à l'autre, c'est-à-dire réalisant une mesure de champ magnétique en deux dimensions (capteur 2D). Pour cela, on réalise sur une première structure similaire à un des capteurs précédemment décrits apte à détecter le champ magnétique $B_{ext1}$ et une seconde structure similaire à un des capteurs précédemment décrits apte à détecter le champ magnétique $B_{ext2}$ qui est perpendiculaire à $B_{ext1}$. Les deux structures permettent donc de mesurer les composantes du champ magnétique selon deux directions perpendiculaires l'une par rapport à l'autre. On obtient ainsi un capteur 2D comportant deux structures de mesure qui correspondent par exemple aux capteurs 100 et 200, ou 100 et 400, ou 100 et 500, ou encore 300 et 200, ou 300 et 400, ou 300 et 500.

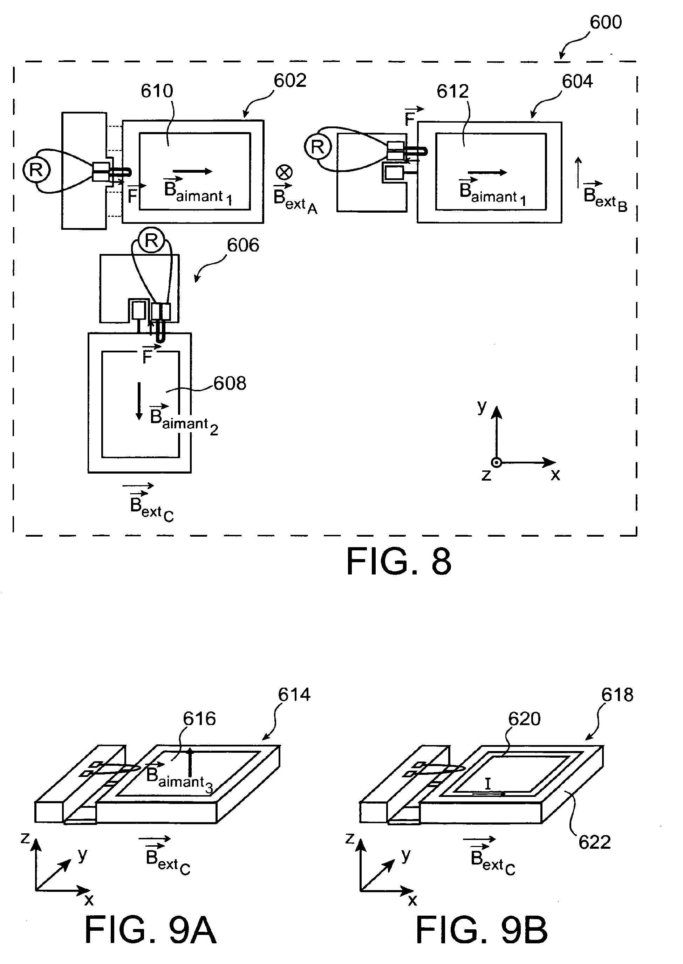

Il est également possible de réaliser un capteur réalisant une mesure d'un champ magnétique comportant des composantes selon 3 axes perpendiculaires les uns par rapport aux autres, c'est-à-dire réalisant une mesure de champ magnétique selon trois directions. Un exemple d'un tel capteur 600 est représenté sur la figure 8. Ce capteur 600 comporte une première structure 602 similaire au capteur 100 précédemment décrit et apte à mesurer une composante $B_{extA}$ du champ magnétique à mesurer parallèle à l'axe Z. Dans une variante, cette première structure 602 pourrait être similaire au capteur 300. Le capteur 600 comporte en outre une seconde structure 604 similaire au capteur 200 précédemment décrit et apte à mesurer une composante $B_{extB}$ du champ magnétique parallèle à l'axe Y. Dans une variante, cette seconde structure 604 pourrait être similaire au capteur 400 ou au capteur 500.

Enfin, le capteur 600 comporte également une troisième structure 606 qui comporte les mêmes éléments que la seconde structure 604, mais ayant subis une rotation à 90° dans le plan (X,Y). Ainsi, la jauge de contrainte de cette troisième structure 606, qui subie une force de compression ou de tension parallèle à l'axe Y, est donc apte à mesurer une composante $B_{extC}$ du champ magnétique parallèle à l'axe X. Le matériau ferromagnétique 608 du corps de cette troisième structure a une orientation magnétique $B_{aimant2}$ perpendiculaire à l'orientation magnétique $B_{aimant1}$ des matériaux ferromagnétiques 610 et 612 de la première et de la deuxième structure 602 et 604, et parallèle à l'axe X. Ce matériau ferromagnétique 608 peut être obtenu, lors de la réalisation du capteur 600, soit en déposant un matériau ferromagnétique ayant dès l'origine une telle orientation magnétique et donc différent des matériaux ferromagnétiques 610 et 612, soit en déposant tout d'abord le même matériau ferromagnétique que celui des première et deuxième structures 604 et 606 (les trois portions de matériau ferromagnétique 608, 610 et 612 ont donc l'orientation magnétique $B_{aimant1}$), puis en chauffant localement, par exemple par laser, tout en appliquant un champ magnétique perpendiculaire d'une valeur inférieure au champ de coercivité des aimants à température ambiante, le matériau ferromagnétique 608 afin de modifier cette orientation magnétique jusqu'à obtenir l'orientation magnétique $B_{aimant2}$.

Les variantes de réalisation précédemment décrites pour le capteur 100 (utilisation d'un matériau ferromagnétique doux couplé ou non avec des moyens d'aimantation) peuvent également s'appliquer aux capteurs 200 à 600 précédemment décrits.

Dans une variante de réalisation de ce capteur 3D, la troisième structure 606 du capteur 600 peut être remplacée par la structure 614 représentée sur la figure 9A. Cette structure 614 est similaire à la première structure 602, exceptée concernant le matériau ferromagnétique 616 de cette troisième structure qui comporte une orientation magnétique $B_{aimant3}$ parallèle à l'axe Z. Un tel matériau ferromagnétique peut être différent à l'origine des matériaux ferromagnétiques 610 et 612, ou être obtenu par chauffage localisé sous champ magnétique d'un matériau ferromagnétique similaire à ceux des première et deuxième structures 602 et 604.

Dans une seconde variante de réalisation, la troisième structure 606 du capteur 600 peut être remplacée par la structure 618 représentée sur la figure 9B. Cette structure 618 est similaire à la structure 614, exceptée que cette structure 618 ne comporte pas de matériau ferromagnétique ni de caisson. En effet, à la différence des structures et des capteurs précédemment décrits, cette structure 618 comporte un corps 622 ici à base de semi-conducteur, par exemple de silicium, en forme de parallélépipède rectangle et de dimensions par exemple similaires à celles du corps 108 décrit en liaison avec les figures 1A et 1B. Une bobine 620 est disposée sur la périphérie d'une face principale du corps 622. Ainsi, lorsque cette bobine 622 est traversée par un courant et en présence du champ magnétique $B_{extc}$, le corps 622 est soumis à une force de rotation analogue à celle que subi le matériau magnétique 616 de la structure 614. Cette structure 618 permet donc de réaliser une détection de la composante $B_{extC}$ du champ magnétique parallèle à l'axe X.

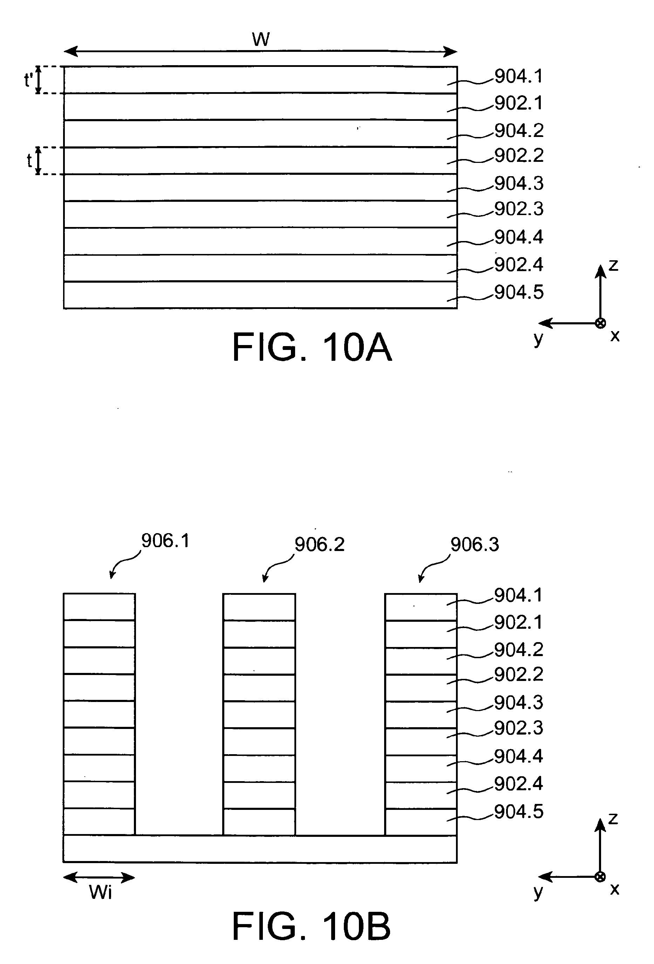

Dans une troisième variante de réalisation, il est possible que les trois structures 602, 604 et 606 comportent, dans le corps respectif de chacune des structures 602, 604 et 606, non pas un seul matériau ferromagnétique 608, 610, 612 comme c'est le cas dans l'exemple représenté sur la figure 8, mais un empilement de couches comprenant, de manière alternée, des couches à base de matériau ferromagnétique et des couches à base de matériau antiferromagnétique, tel que représenté sur la figure 10A. Cet empilement peut être formé de sorte que chaque couche à base de matériau ferromagnétique, référencées 902.1 - 902.4 sur l'exemple de la figure 10A, soit disposée entre deux couches de matériau antiferromagnétique 904.1 - 904.5.

Le matériau ferromagnétique peut être un matériau ferromagnétique doux, ayant une forte aimantation à saturation, par exemple supérieure à environ 1000 emu/cm$^3$ (environ 1,26 T). Un tel matériau ferromagnétique peut être par exemple un alliage de Fe, de Co, et de Ni. Le matériau antiferromagnétique peut être un alliage à base de Mn, par exemple du type NiMn, ou PtMn, ou PdPtMn. Selon d'autres exemples, le matériau antiferromagnétique peut être du FeMn, ou de l'IrMn, ou du NiO, ou du $Fe_2O_3$.

Etant donné que les couches de matériau antiferromagnétique 904.1 - 904.5 sont disposées de part et d'autre de chacune des couches de matériau ferromagnétique 902.1 - 902.4, un couplage d'échange aux interfaces entre le matériau antiferromagnétique et le matériau ferromagnétique permet de bloquer l'aimantation de la couche de matériau ferromagnétique intercalée dans une direction définie lors d'un recuit de mise en ordre définissant l'orientation magnétique de ces matériaux.

Les couches de matériau antiferromagnétique 904.1 - 904.5 peuvent avoir une épaisseur t' (dimension selon l'axe z représenté sur la figure 10A) par exemple comprise entre environ 2 nm et 50 nm, par exemple de l'ordre de 20 nm. Les couches à base de matériau ferromagnétique 902.1 - 902.4 peuvent avoir une épaisseur t (dimension selon l'axe z représenté sur la figure 10A) par exemple comprise entre environ 2 nm et 40 nm, par exemple de l'ordre de 10 nm. Cet empilement comporte par exemple un nombre total de couches compris entre environ 8 et 50 (9 sur l'exemple de la figure 10A), le nombre de couches étant adapté notamment en fonction des épaisseurs t et t' des couches afin que l'empilement ait une épaisseur totale par exemple comprise entre environ 100 nm et 600 nm, et par exemple sensiblement égale à environ 100 nm.

Ces empilements de couches forment, dans chaque structure 602, 604 et 606 du capteur 600, des blocs parallélépipédiques rectangles, de forme allongée ou longiligne. Ainsi, chaque bloc formé par un tel empilement de couches comporte une largeur W (dimension selon l'axe y de la figure 10A, correspondant aux dimensions selon l'axe y pour les structures 602 et 604 représentées sur la figure 8, et selon l'axe x pour la structure 606 de la figure 8) par exemple comprise entre environ 20 μm et 500 μm, par exemple de l'ordre de 20 μm, et une longueur L (dimension selon l'axe x de la figure 10A, correspondant aux dimensions selon l'axe x pour les structures 602 et 604 de la figure 8, et selon l'axe y pour la structure 606 de la figure 8) par exemple comprise entre environ 20 μm et 500 μm, par exemple de l'ordre de 100 μm. Le rapport d'aspect L/W de chaque bloc peut être important et par exemple supérieur ou égal à 5.

Dans une variante, un ou plusieurs de ces empilements de couches des structures 602, 604 et 606 peuvent être sous la forme d'un ensemble de sous-blocs, référencés 906.1 à 906.3 sur un exemple de la figure 10B, parallélépipédiques rectangles, parallèles et disjoints entre eux. Subdiviser les blocs, ou empilements de couches, en sous-blocs parallélépipédiques, ayant en particulier chacun un rapport d'aspect entre une longueur L et une largeur Wi important, par exemple tel que $L/W_i \geq 10$, permet d'introduire une anisotropie de forme dans une direction orthogonale à la direction du champ magnétique à détecter, et donc de garantir un bon alignement des aimantations le long de leurs directions principales respectives correspondant à la direction de leur plus grande dimension L. Cette largeur Wi est par exemple comprise entre environ 0,25 $\mu$m et 10 $\mu$m, et préférentiellement inférieure à environ 5 $\mu$m. De tels sous-blocs peuvent être obtenus en effectuant une gravure par exemple de type IBE (gravure ionique) dans les couches de matériaux ferromagnétique et antiferromagnétique empilées.

Les empilements de couches de matériaux ferromagnétique et antiferromagnétique sont destinés être orientés magnétiquement de manière similaire aux matériaux magnétiques 608, 610 et 612 représentés sur la figure 8, c'est-à-dire selon la direction de l'orientation magnétique $B_{aimant1}$ pour les structures 602 et 604, et selon la direction de l'orientation magnétique $B_{aimant2}$ pour la structure 606, ces deux orientations magnétiques $B_{aimant1}$ et $B_{aimant2}$ étant perpendiculaires l'une par rapport l'autre.

Lors de la réalisation des structures 602, 604 et 606 selon cette variante de réalisation, après avoir réalisé les empilements de couches 902.1 - 902.4 et 904.1 - 904.5, on effectue un recuit de mise en ordre magnétique, dont la température permet de réaliser une mise en ordre du matériau antiferromagnétique.

Lorsque le matériau antiferromagnétique est non ordonné, par exemple du type NiMn, ou PtMn, ou PdPtMn, c'est-à-dire un matériau qui ne présente pas de couplage d'échange après dépôt, l'étape de recuit est effectuée à une température supérieure ou égale à la température de mise en ordre de ce matériau. Cette température de mise en ordre est typiquement supérieure à environ 250°C. Pour un matériau antiferromagnétique ordonné tel que du FeMn, ou du IrMn, ou du NiO, ou du $Fe_2O_3$, c'est-à-dire qui présente un couplage d'échange après dépôt, l'étape de recuit est effectuée à une température supérieure à la température de blocage ou de la température de Néel de ce matériau, soit typiquement comprise entre environ 150°C et 250°C. Le recuit peut être effectué par exemple à une température supérieure à 260°C lorsque le matériau antiferromagnétique est du PtMn.

Au cours du recuit, en particulier au début de celui-ci, on applique un champ magnétique B, orienté de manière à former un angle non nul, et par exemple égale à environ 45°, par rapport aux orientations magnétiques $B_{aimant1}$ et $B_{aimant2}$.

Le champ magnétique appliqué peut être un champ saturant d'intensité $\left\|\vec{B}\right\|$ = Bsat prévue supérieure à une valeur prédéterminée de champ correspondant au champ de saturation des blocs selon leur axe difficile.

L'axe difficile est l'axe pour lequel le champ magnétique appliqué pour aligner l'aimantation du bloc, c'est-à-dire de l'empilement de couches, est le plus important, soit le champ magnétique nécessaire pour saturer l'aimantation le long de la plus petite dimension, c'est-à-dire la largeur W, des empilements de couches. Dans un cas où l'on réalise des empilements de couches de largeurs différentes, un champ magnétique saturant supérieur au champ de saturation de l'empilement de couches de plus faible largeur est appliqué.

Le champ saturant appliqué peut être très supérieur à ladite valeur prédéterminée, et peut être par exemple de l'ordre 1T ou 2T.

Au cours du recuit, on réduit l'intensité du champ magnétique appliqué, de sorte que le module du champ magnétique appliqué projeté le long de l'axe x, correspondant à l'axe dans lequel la longueur des empilements de couches des structures 602 et 604 est mesurée, est supérieur ou égal à un champ de saturation $H_L$ des empilements de couches des structures 602 et 604, et que le module du champ magnétique appliqué projeté le long de l'axe y, correspondant à l'axe dans lequel la longueur de l'empilement de couches de la structure 606 est mesurée, est supérieur ou égal au champ de saturation $H_L$ du de l'empilement de couches de la structure 606.

Ainsi, le module du champ magnétique appliqué projeté le long de l'axe y est inférieur au champ de saturation des empilements de couches des structures 602 et 604 selon leur axe difficile d'aimantation. De plus, le module du champ magnétique appliqué projeté le long de l'axe x est inférieur au champ de saturation selon l'axe difficile d'aimantation de l'empilement de couches de la structure 606.

Le module du champ magnétique appliqué projeté le long de l'axe y peut être 20 fois plus faible que le champ de saturation des empilements de couches des structures 602 et 604 selon leur axe difficile d'aimantation, afin de garantir un alignement des aimantations dans les empilements de couches des structures 602 et 604 à 5° de leur direction principale (direction parallèle à leur longueur L).

Le champ de saturation $H_L$ d'un empilement de couches de longueur L orientée selon l'axe x peut être évalué à l'aide de la formule suivante :

$$H_L = \frac{Wt}{L^2}\left[\ln\left(\frac{4L}{W}\right) - 1\right] * 4 * \pi * Ms$$

Le champ de saturation $H_W$ de ce même empilement de couches selon l'axe y peut être évalué à l'aide la formule suivante :

$$Hw = 4 * \pi * Ms * t * \left[ \frac{1}{t+W} - \frac{W}{L^2} \left[ \ln\left(\frac{4L}{W}\right) - 1 \right] \right]$$

avec :

t : épaisseur de l'ensemble des couches à base de matériau ferromagnétique pour un empilement ;

$M_S$ : aimantation à saturation du matériau ferromagnétique ;

L : dimension la plus grande des couches de matériaux magnétiques, c'est-à-dire la longueur ;

W : dimension la plus petite des couches de matériaux magnétiques, c'est-à-dire la largeur.

Par exemple, pour des empilements de couches d'environ 100 $\mu$m de longueur, 2 $\mu$m de largeur et d'environ 100 nanomètres d'épaisseur, on a $H_L$ = $1.10^{-4}$ T et $H_W$ = 0, 513 T.

En appliquant un champ de 0,03 T à 45°, on peut obtenir une orientation de l'aimantation à mieux que 5° du grand axe d'un bloc quelque soit son orientation.

Le module du champ projeté le long de la dimension la plus petite est de préférence inférieur à environ 5% de $H_L$ afin de garantir un alignement meilleur que 5° par rapport à la dimension la plus grande et inférieur à environ 2% pour un alignement meilleur que 2° par rapport à la dimension la plus grande.

Dans le cas où les empilements de couches des structures 602 et 604 ont des largeurs différentes, on obtiendra alors des alignements différents par rapport aux directions principales, c'est-à-dire les directions selon les longueurs L de chaque empilement de couches.

Par exemple, si les couches de l'empilement de la structure 602 ont une première largeur W = W1 = 10 $\mu$m et que les couches de l'empilement de la seconde structure 604 ont une deuxième largeur W = W2 = 2 $\mu$m, les couches des empilements des structures 602 et 604 ayant une longueur L = 100 $\mu$m et qu'on applique par exemple un champ magnétique égal à environ 0,03 T, l'aimantation dans l'empilement de couches de la structure 602 sera désalignée d'environ 20° par rapport à sa direction principale alors que le désalignement ne sera que de 5° dans l'empilement de couches de la structure 604.

Pour ne pas avoir à mettre en oeuvre des champs magnétiques trop faibles dans le four de recuit il peut être préférable de réaliser des empilements de couches de largeur W inférieure à environ 2 $\mu$m.

Après avoir réduit l'intensité du champ magnétique, on réduit la température de recuit afin de générer dans chaque empilement de couches, un échange entre le matériau antiferromagnétique et le matériau ferromagnétique, ce qui permet de figer définitivement les directions d'aimantation.

A l'issue du recuit, on obtient des structures 602 et 604 comportant chacune un empilement de couches de matériaux ferromagnétique et antiferromagnétique ayant une orientation d'aimantation identique dans une direction qui peut être sensiblement parallèle à celle de l'axe x ou différer de moins de 5° de celle de l'axe x, tandis que la structure 606 peut comporter un empilement de couches de matériaux ferromagnétique et antiferromagnétique ayant une aimantation d'orientation différente, qui est sensiblement orthogonale à celle des empilements de couches des structures 602 et 604.

Avec un tel capteur, si un champ magnétique perturbateur fort comme celui d'un aimant venait renverser l'orientation d'aimantation des structures 602, 604 et 606, cette orientation serait restaurée dès que l'aimant serait éloigné du capteur. Le long du petit axe (largeur), l'aimantation pourrait tourner en présence d'une perturbation magnétique mais retournerait à sa position initiale en fin de perturbation.

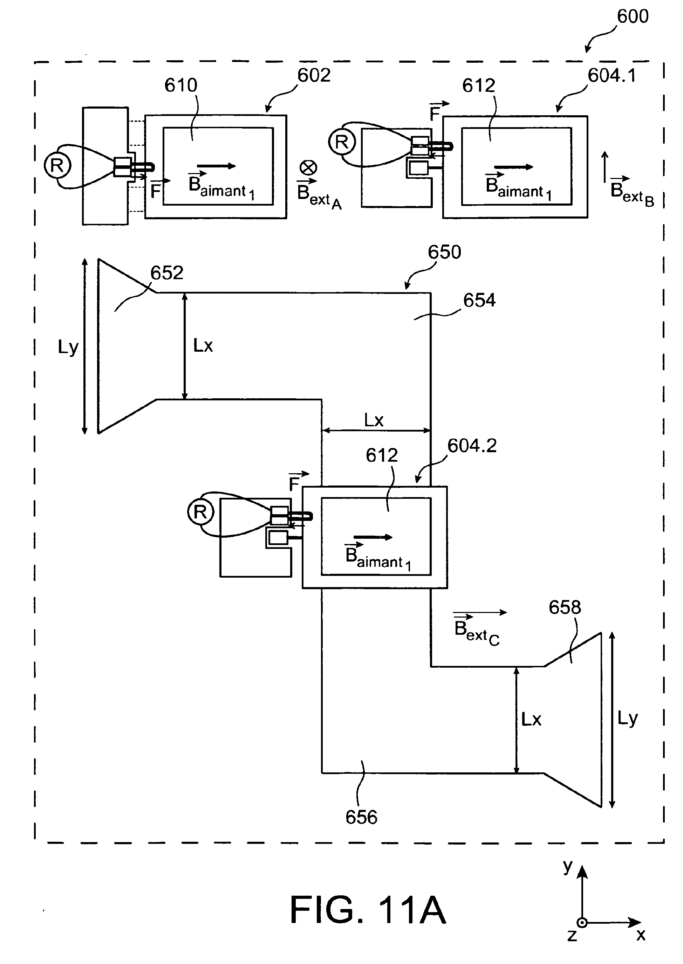

Dans une quatrième variante de réalisation du capteur 600 représentée sur la figure 11A, il est possible que celui-ci soit réalisé à partir de la première structure 602 et de deux structures 604.1 et 604.2 similaires à la structure 604 représentée sur la figure 8. De manière analogue au capteur 600 représenté sur la figure 8, la première structure 602 permet de mesurer la composante $B_{extA}$ du champ magnétique qui est parallèle à l'axe z et la seconde structure 604.1 permet de mesurer la composante $B_{extB}$ du champ magnétique qui parallèle à l'axe y.

Ce capteur 600 comporte en outre une troisième structure 604.2, similaire à la seconde structure 604.1. Cette troisième structure 604.2 est couplée à un guide de flux magnétique 650 permettant de réorienter la composante $B_{extC}$ du champ magnétique dans une direction perpendiculaire à la direction d'aimantation $B_{aimant1}$ du matériau magnétique 612 de la troisième structure 604.2, à savoir parallèlement à l'axe y, permettant à la troisième structure de mesurer la composante $B_{extC}$ du champ magnétique.

Le guide de flux 650 est réalisé à partir de matériau ferromagnétique doux et comporte une structure permettant de réorienter les lignes de champ magnétique parallèles à l'axe x en lignes de champ magnétique parallèles à l'axe y.

Le guide de flux magnétique 650 comporte un élément d'entrée 652 en forme d'entonnoir présentant une entrée de largeur égale à Ly et une sortie de largeur égale à Lx correspondant à la longueur (dimension selon l'axe x) du bloc formé par le matériau magnétique 612. L'élément d'entrée 652 est relié à un premier élément coudé 654 qui forme un angle à 90° et permet de réorienter parallèlement à l'axe y les lignes de champ magnétique qui sont entrées dans l'élément d'entrée 652. Ce champ magnétique réorienté peut ensuite être mesuré par la troisième structure 604.2. Le guide de flux magnétique 650 comporte également un second élément coudé 656 permettant de réorienter les lignes de champs parallèlement à l'axe x, ces lignes réorientées étant ensuite « évacuées » par un élément de sortie 658 en forme d'entonnoir inversé, présentant une entrée de largeur égale à Lx et une sortie de largeur égale à Ly. Les différents éléments du guide de flux magnétique 650 forment une structure symétrique autour de la troisième structure 604.2.

L'élément d'entrée 652 du guide de flux magnétique 650 permet de réaliser une amplification des lignes de champs sensiblement proportionnelle au rapport Ly/Lx, qui peut être par exemple égal à environ 5. Ainsi, pour une composante $B_{extC}$ = 50 $\mu$T, l'induction mesurée par la troisième structure 604.2 peut correspondre à une induction orientée parallèlement à l'axe y telle que By = -218 $\mu$T. Pour une composante $B_{extC}$ = - 50 $\mu$T, l'induction mesurée par la troisième structure 604.2 peut correspondre à une induction orientée parallèlement à l'axe y telle que By = 225 $\mu$T.

L'utilisation d'un tel guide de flux magnétique 650 permet de réaliser un capteur tri-axe à partir de structures pouvant être toutes réalisées à partir d'un matériau magnétique de même orientation magnétique ($B_{aimant1}$ sur l'exemple de la figure 11A) .

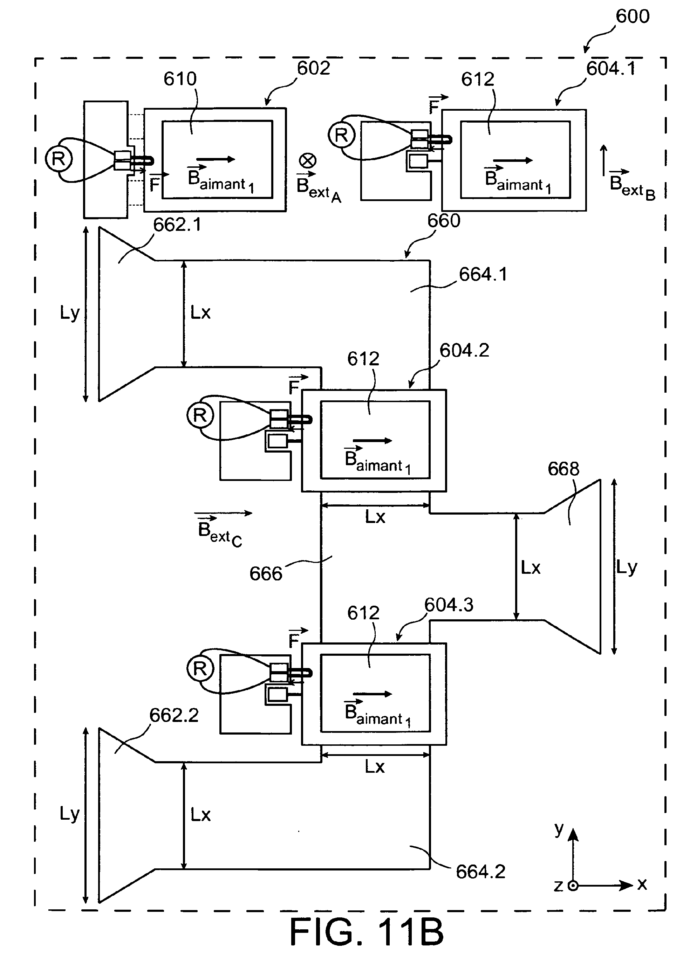

Dans l'exemple du capteur 600 représenté sur la figure 11A, la troisième structure 604.2 couplée au guide de flux magnétique 650 permet de mesurer la composante $B_{extC}$ du champ magnétique. Toutefois, la troisième structure 604.2 est sensible à la composante $B_{extB}$ du champ magnétique ainsi qu'à une éventuelle accélération parallèle à l'axe y. Afin d'insensibiliser la structure destinée à mesurer la composante $B_{extC}$ du champ magnétique par rapport à la composante $B_{extB}$ du champ magnétique et à une accélération selon l'axe y, le capteur 600 peut être réalisé selon une autre variante représentée sur la figure 11B.

Dans cette variante de réalisation du capteur 600 représentée sur la figure 11B, celui-ci comporte la structure 602 et trois structures similaire à la structure 604 de la figure 8, référencées 604.1, 604.2 et 604.3 sur la figure 11B. De manière analogue au capteur 600 représenté sur la figure 11A, la première structure 602 permet de mesurer une composante $B_{extA}$ du champ magnétique à mesurer parallèle à l'axe Z et la seconde structure 604.1 permet de mesurer une composante $B_{extB}$ du champ magnétique parallèle à l'axe Y.

Les deux autres structures 604.2 et 604.3 fonctionnent de manière différentielle afin de mesurer la composante $B_{extC}$ du champ magnétique. Pour cela, ces deux structures 604.2 et 604.3 sont couplées à un guide de flux 660. Le guide de flux 660 comporte un premier élément d'entrée 662.1 et un premier élément coudé 664.1, par exemple similaires à l'élément d'entrée 652 et au premier élément coudé 654 précédemment décrits en liaison avec la figure 11A, le premier élément coudé 664.1 permettant d'amener les lignes de champ réorientées parallèlement à l'axe y dans la troisième structure 604.2. De manière analogue, le guide de flux 660 comporte un second élément d'entrée 662.2 et un second élément coudé 664.2 permettant de réorienter des lignes de champ de la composante $B_{extC}$ du champ magnétique parallèlement à l'axe y et dans une direction opposée à celle de la réorientation réalisée par le premier élément d'entrée 662.1 et le premier élément coudé 664.1. Le guide de flux 660 comporte également un troisième élément 666 permettant de réorienter les lignes de champ sortantes des structures 604.2 et 604.3 et de les acheminer vers un élément de sortie 668 par exemple similaire à l'élément de sortie 658 précédemment décrit en liaison avec la figure 11A.

Dans cette variante, les éléments de liaison du corps et les jauges de contraintes des troisième et quatrième structures 604.2 et 604.3 sont disposés du même côté du corps afin que l'ensemble formé par les troisième et quatrième structures 604.2 et 604.3 ainsi que le guide de flux magnétique 660 soit insensible à la composante $B_{extB}$ du champ magnétique et à une accélération parallèle à l'axe y.

Le ou les éléments d'entrée des guides de flux 650 et 660 peuvent également être réalisés de manière non évasée, ces éléments comportant dans ce cas une largeur uniforme Lx. Dans ce cas, les guides de flux 650 et 660 réalisent une réorientation des lignes de champ sans amplification préalable. Il serait également possible que le ou les éléments d'entrée soient réalisés de manière non évasée, mais que le ou les éléments coudés des guides de flux comportent une partie évasée afin de réaliser une amplification non pas des lignes de champs selon la composante $B_{extC}$ du champ magnétique, mais une amplification des lignes de champ réorientées parallèlement à l'axe y.

Les capteurs décrits précédemment sont réalisés en technologie de surface à partir d'un substrat SOI, permettant ainsi à ces capteurs d'être réalisés de manière complètement intégrés dans le substrat SOI.

Dans une variante des capteurs 100 à 500 précédemment décrits, les corps de ces capteurs comportant un matériau ferromagnétique disposé dans un caisson peuvent être remplacés par des corps monolithiques comportant chacun une bobine disposée sur une des faces principales du corps, de manière analogue à la structure de détection 618 décrite ci-dessus. De plus, dans une autre variante, les corps des capteurs précédemment décrits pourraient ne pas comporter un caisson dans lequel est disposé un matériau ferromagnétique, mais être formé par plusieurs couches de matériau magnétiques empilées les unes sur les autres.

De plus, dans les capteurs 100 à 600 précédemment décrits, le ou les matériaux ferromagnétiques utilisés peuvent être durs ou doux. Enfin, lorsqu'un des capteurs 100 à 600 est réalisé avec un matériau ferromagnétique doux, il est également possible que ce matériau soit disposé sous la forme d'un empilement de couches à base de matériaux ferromagnétique et antiferromagnétique, tel que précédemment décrit en variante de réalisation du capteur 600.

Lorsque l'un des capteurs 100 à 600 fait appel à un matériau ferromagnétique doux ou à un corps monolithique comportant une bobine (comme par exemple la structure de détection 618 précédemment décrite), c'est-à-dire lorsque la grandeur sensible du capteur au champ à mesurer est variable, on peut faire varier cette grandeur sensible à une fréquence sensiblement proche d'une fréquence de résonance mécanique du corps du capteur, permettant de faire entrer en résonance le corps du capteur et amplifier la force s'exerçant sur les moyens de détection du capteur par le facteur de qualité du résonateur mécanique ainsi formé.

Dans une variante de réalisation des différents capteurs précédemment décrits dans lesquels les corps ont une forme sensiblement rectangulaire et dont l'axe des moyens de liaison se trouve sensiblement au niveau d'un des côtés du corps, les corps de ces capteurs peuvent avoir une forme telle que le centre de gravité du corps se trouve sensiblement au niveau de l'axe de pivot des moyens de liaison du capteur.

En effet, en présence d'une accélération, le corps du capteur subit un champ de force $\delta\vec{F} = \rho\vec{a}$ , avec $\vec{a}$ l'accélération et $\rho$ la masse volumique du matériau du corps. Le couple qui résulte de ce champ de force en un point de coordonnées $\vec{r}$ s'écrit :

$$\vec{C}_{pivot} = \int_V (\vec{r} - \vec{r}_0) \times \delta\vec{F} dV \ ,$$

ou $\vec{r}_o$ est la coordonnée du pivot et V le volume du corps. Vu que $\delta\vec{F}$ peut être considéré comme cosntant à l'échelle du corps, si le corps est équilibré au niveau du pivot, se traduisant par le fait que $\int_V (\vec{r} - \vec{r}_0) dV = 0$ , alors se couple $\vec{C}_{pivot}$ d\$s'exerçant sur le corps an niveau du pivot est nul, de meme que la sensibilité du corps aux accélérations.

De la même manière, les moyens magnétiques, situés sur le corps du capteur, peuvent être avantageusement équilibrés par rapport au pivot de sorte que le couple qui s'exerce au niveau de ce pivot et qui résulte du champ de force s'exerçant sur un matériau magnétique en présence d'un gradient de champ $\delta\vec{F} = (\vec{m} \cdot \vec{grad})\vec{B}$ soit sensiblement proche de 0 dans ce cas, et par conséquent que la sensibilité du capteur aux gradients de champ le soit aussi.

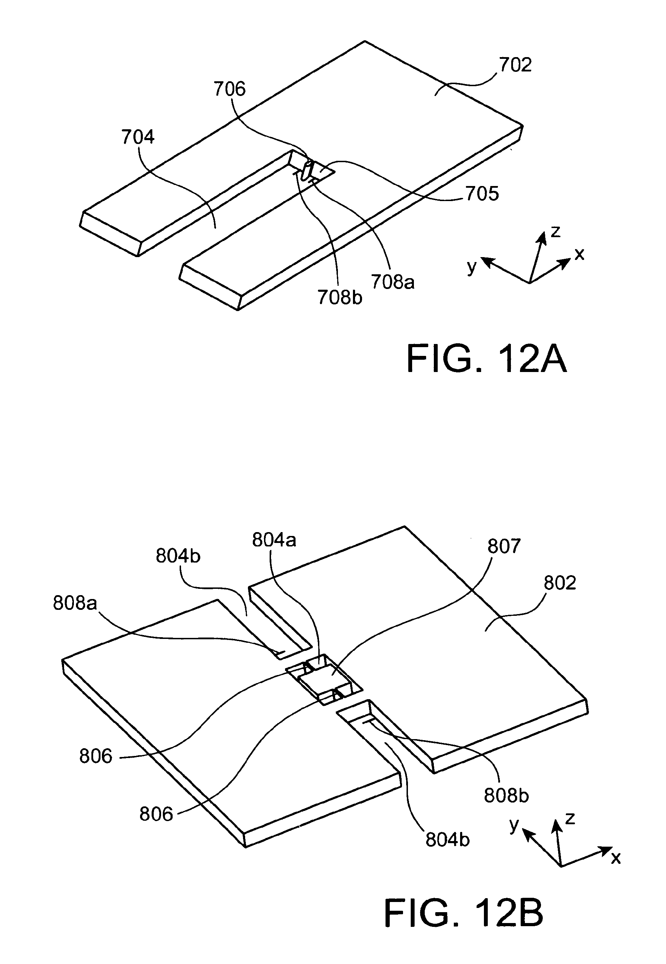

Un premier exemple de réalisation d'un tel corps 702 est représenté schématiquement sur la figure 12A. Les moyens magnétiques, bien que non représentés sur cette figure, sont répartis de manière équilibrée et homogène sur et/ou dans le corps 702. Sur cette figure 12A, le corps 702 a une forme, dans le plan (x,y), sensiblement rectangulaire, dont la dimension selon l'axe x est supérieure à celle selon l'axe y, comportant un évidement 704 formant un accès au centre de gravité du corps 702. Le corps 702 a donc une forme de « U » dont le centre de gravité se trouve sensiblement au niveau d'une paroi 705 révélée par l'évidement 704. Le corps 702 est relié à une charnière 706 sensiblement au niveau de son centre de gravité (par la paroi 705), cette charnière 706 étant destinée à être également reliée à une zone d'encastrement du capteur non représentée sur la figure 12A. Deux jauges de contraintes 708a, 708b du capteur comportant le corps 702 sont également reliées à la paroi 705 du corps 702. Un tel corps 702 forme une masse équilibrée autour de l'axe de liaison de la charnière 706 (axe parallèle à l'axe z) et peut par exemple être utilisé dans le capteur 400 précédemment décrit, à la place du corps 108, afin de détecter un champ magnétique orienté selon l'axe y.

Un second exemple de réalisation d'un tel corps 802 est représenté schématiquement sur la figure 12B. Là encore, les moyens magnétiques ne sont pas représentés mais sont par exemple répartis de manière homogène et équilibrée sur et/ou dans le corps 802. Sur cette figure 12B, le corps 802 a une forme, dans le plan (x,y), sensiblement rectangulaire. Le corps 802 comporte un évidement central 804 dans lequel est disposé une zone d'encastrement 807 du capteur reliée au corps 802 par deux charnières 806 formant un axe de liaison parallèle à l'axe y sensiblement au niveau du centre de gravité du corps 802. Le corps 802 comporte en outre deux autres évidements 804b dans lesquels des jauges de contraintes 808a, 808b sont disposées et reliées au corps 802.

Un tel corps 802 forme une masse équilibrée autour de l'axe de liaison formé par les charnières 806 et peut par exemple être utilisé dans le capteur 100 précédemment décrit, à la place du corps 108, afin de détecter un champ magnétique orienté selon l'axe z.

Il est possible de réaliser en outre une encapsulation des capteurs précédemment décrits, par exemple lorsque l'on souhaite que ces capteurs fonctionnent sous une atmosphère particulière. Une telle encapsulation peut également permettre de protéger les matériaux ferromagnétiques utilisés tels que le NdFeB ou le SmCo qui sont sensibles à la corrosion et aux attaques chimiques, et mécaniquement fragiles. Une telle encapsulation peut être réalisée de manière analogue à une encapsulation classique de dispositif de type MEMS. De plus, une encapsulation sous vide des capteurs précédemment décrits permet de réduire le bruit Brownien. Les matériaux magnétiques peuvent dans ce cas être protégés par des couches de passivation.

Enfin, tous les capteurs précédemment décrits peuvent comporter une cellule d'amplification de contrainte comprenant par exemple au moins deux bras rigides reliés mécaniquement l'un à l'autre par au moins un élément de liaison au niveau d'une première de leurs extrémités, une seconde extrémité d'un premier des deux bras rigides étant reliée mécaniquement au corps, une seconde extrémité d'un second des deux bras rigides étant reliée à une zone d'encastrement, ledit élément de liaison, ou les premières extrémités des deux bras rigides, étant relié mécaniquement à une extrémité de la jauge de contrainte suspendue (cette extrémité correspondant à celle reliée au corps des capteurs précédemment décrits). Une telle cellule d'amplification de contrainte peut notamment être réalisée dans le plan du capteur, par exemple dans la couche superficielle du substrat SOI à partir duquel est réalisé le capteur. En couplant les capteurs de champ magnétique décrits précédemment avec une ou plusieurs cellules d'amplification de contraintes, on améliore la sensibilité des mesures de champ magnétique réalisées par ces capteurs.

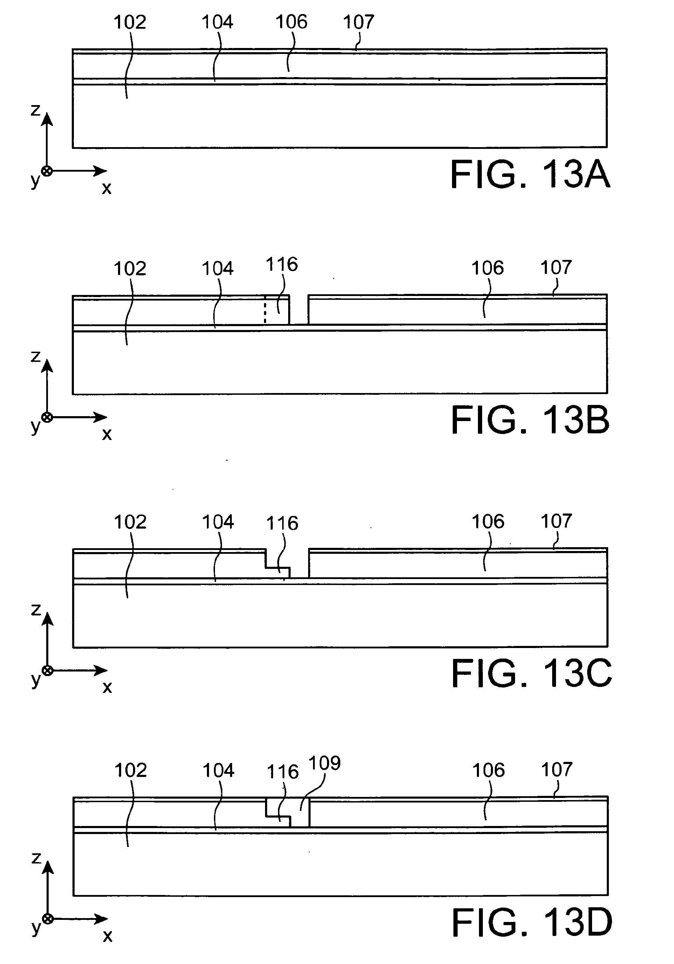

On décrit maintenant en liaison avec les figures 13A à 13J (vues de profil) un exemple d'un premier procédé de réalisation du capteur 100 précédemment décrit en liaison avec les figures 1A et 1B.

Comme représenté sur la figure 13A, le capteur 100 est réalisé à partir d'un substrat SOI comportant les couches 102, 104 et 106 précédemment décrites. Dans cet exemple de réalisation, la couche 102 de silicium a une épaisseur égale à environ 750 $\mu$m, la couche de SiO$_2$ 104 a une épaisseur égale à environ 0,4 $\mu$m et la couche superficielle de silicium 106 a une épaisseur égale à environ 5 $\mu$m. Une couche 107 à base de SiN est en outre déposée sur la couche superficielle 106, par exemple par LPCVD (dépôt chimique en phase vapeur à basse pression). Cette couche 107 est destinée à former un masque de gravure.

On réalise ensuite une lithographie et une gravure, par exemple DRIE (gravure ionique réactive profonde), dans la couche superficielle 106 pour libérer des portions de la couche superficielle 106 destinées à former les charnières 116 (figure 13B). Cette gravure est réalisée avec arrêt sur la couche diélectrique 104.

Comme représenté sur la figure 13C, on réalise ensuite un amincissement desdites portions de la couche superficielle 106 afin de former les charnières 116. Cet amincissement est réalisé jusqu'à obtenir l'épaisseur (dimension selon l'axe Z) souhaitée pour les charnières 116. Cet amincissement est réalisé lorsque les charnières ont une épaisseur inférieure à celle du corps du capteur, comme c'est le cas pour les capteurs 100 et 300. Toutefois, lorsque l'on réalise l'un des capteurs 200, 400 ou 500 dans lesquels l'épaisseur de la charnière est sensiblement égale à celle du corps, cette étape d'amincissement n'est pas mise en oeuvre.

On dépose ensuite un oxyde de bouchage 109, par exemple du verre de phosphosilicate, sur l'ensemble du dispositif afin de remplir temporairement les espaces vides autour des charnières 116. L'oxyde de bouchage se trouvant sur la couche de SiN 107 est ensuite supprimé par exemple par une planarisation mécano-chimique avec arrêt sur la couche de SiN 107 afin de ne conserver que l'oxyde de bouchage 109 se trouvant dans les cavités formées dans la couche superficielle 106 par la précédente étape de gravure (figure 13D).

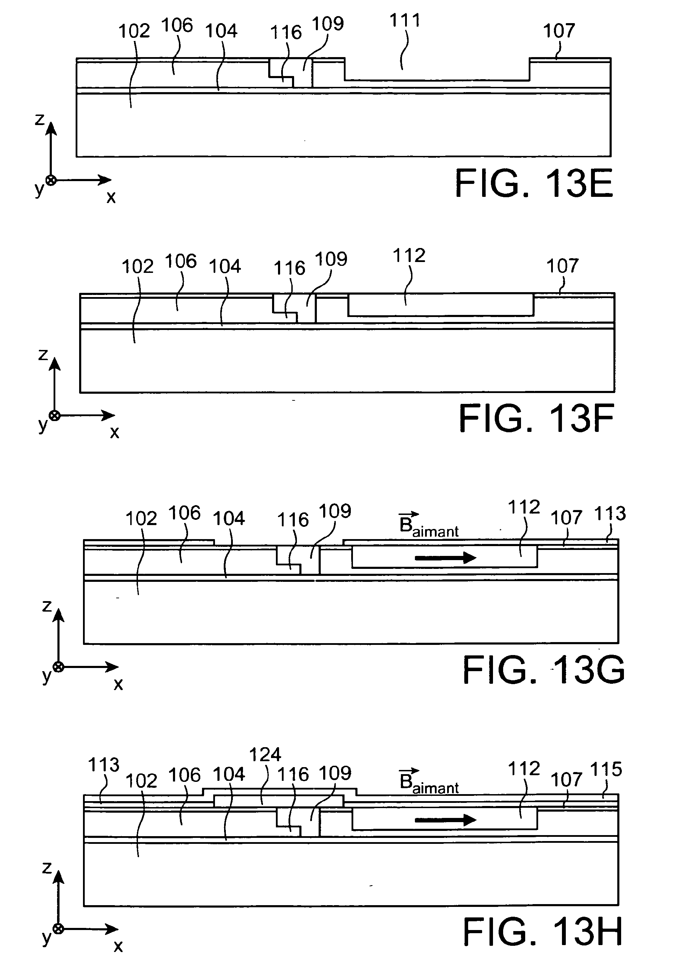

Comme représenté sur la figure 13E, on réalise une lithographie et une gravure au temps, par exemple DRIE, dans la couche superficielle de silicium 106 avec arrêt dans la couche superficielle de silicium 106 pour former un emplacement 111 dans lequel le matériau ferromagnétique 112 du capteur 100 est destiné à être déposé.

Le matériau ferromagnétique est ensuite déposé sur l'ensemble du dispositif afin de remplir l'emplacement 111. Le matériau ferromagnétique se trouvant sur la couche de SiN 107 est ensuite supprimé par exemple par une planarisation mécano-chimique avec arrêt sur la couche de SiN 107 afin de ne conserver que le matériau ferromagnétique 112 se trouvant dans l'emplacement 111 (figure 13F).

On réalise ensuite un recuit et une aimantation du matériau ferromagnétique 112 afin de définir la direction d'aimantation B$_{aimant}$ du matériau 112, ici parallèle à l'axe X. On dépose ensuite une couche de passivation 113, par exemple à base de SiN et par exemple d'épaisseur égale à environ 0,3 $\mu$m, sur le dispositif, excepté à l'emplacement au niveau duquel la jauge de contrainte est destinée à être suspendue (figure 13G).

On réalise ensuite un dépôt de la jauge métallique 124 puis un dépôt d'une couche de protection 115 à base de SiO$_2$ sur l'ensemble du dispositif, destinée à protéger notamment la jauge de contrainte 124 (figure 13H).

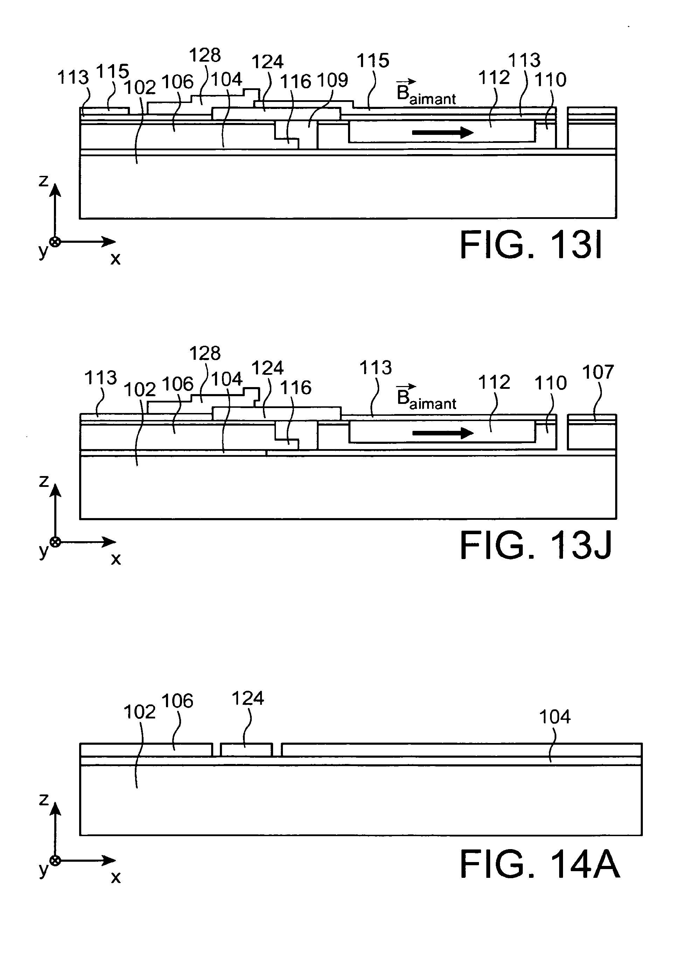

Comme représenté sur la figure 13I, on réalise alors des ouvertures dans le couche de protection 115 et notamment au-dessus des extrémités libres de la jauge de contrainte 124 afin de réaliser les contacts électriques 128 par dépôt de métallisations, et réaliser également une gravure profonde dans la couche superficielle 106 afin de délimiter et former le contour du caisson 110. Enfin, on réalise une gravure de l'oxyde présent sur le dispositif, c'est-à-dire la couche de protection 115, ainsi que l'oxyde de bouchage 109 et la portion de la couche de SiO$_2$ 104 se trouvant sous le caisson 110 et sous les charnières 116, libérant ainsi le corps 108 et les charnières 116 du reste du capteur 100 (figure 13J).

Bien que décrit pour la réalisation du capteur 100, les étapes décrites ci-dessus pourraient également s'appliquer pour la réalisation des autres capteurs 200, 300, 400, 500 et 600 précédemment décrits.

On décrit maintenant en liaison avec les figures 14A à 14H (vues de profil) un exemple d'un second procédé de réalisation du capteur 200, dans sa variante décrite en liaison avec la figure 3, c'est-à-dire comportant une jauge piézorésistive formée par une poutre de silicium.

Comme représenté sur la figure 14A, le capteur est réalisé à partir d'un substrat SOI comportant les couches 102, 104 et 106 précédemment décrites. Dans cet exemple de réalisation, la couche 102 de silicium a une épaisseur égale à environ 750 $\mu$m, la couche de SiO$_2$ 104 a une épaisseur égale à environ 0,4 $\mu$m et la couche superficielle de silicium 106 a une épaisseur égale à environ 200 nm. On réalise une gravure dans la couche superficielle 106 afin de former la jauge piézorésistive 124, c'est-à-dire ici une nano-poutre de silicium.

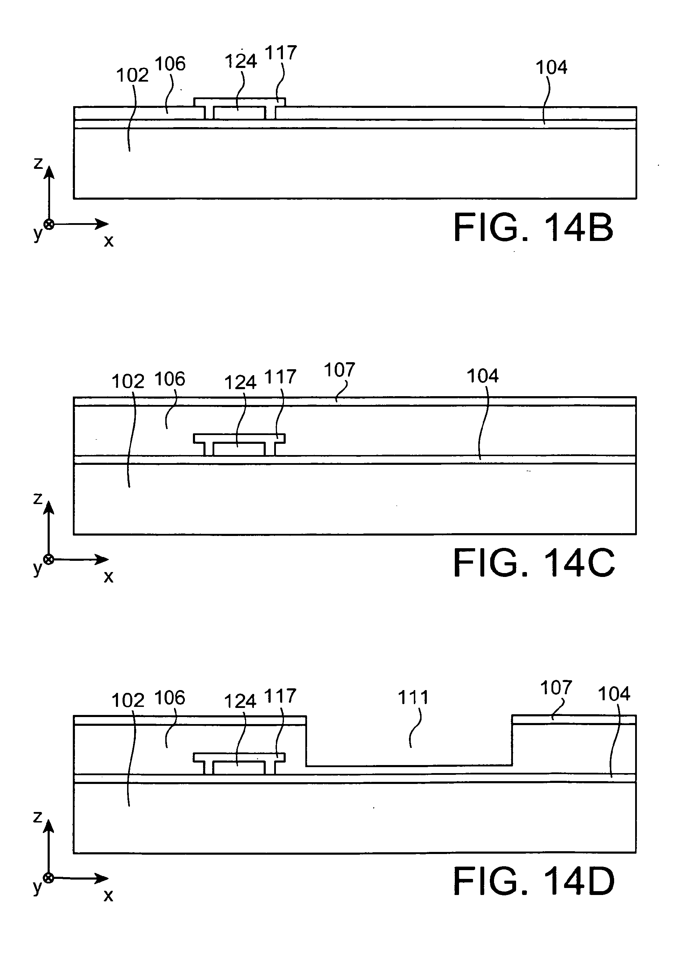

Comme représenté sur la figure 14B, on réalise ensuite un dépôt d'oxyde sur le dispositif, remplissant ainsi les zones précédemment gravées dans la couche 106 définissant la jauge de contrainte piézorésistive 124. Cet oxyde est ensuite gravé afin de ne conserver qu'une portion 117 au niveau de la jauge piézorésistive 124.

On réalise ensuite une épitaxie épaisse de la couche de silicium 106, recouvrant notamment la portion d'oxyde 117, puis le dépôt d'une couche de passivation 107, ici à base de SiN, sur la couche 106 épitaxiée (figure 14C).

De manière analogue à la figure 13E, on réalise une lithographie et une gravure au temps, par exemple DRIE, dans la couche de silicium épitaxiée 106, avec arrêt dans la couche de silicium épitaxiée 106, pour former l'emplacement 111 dans lequel le matériau ferromagnétique 112 du capteur 200 est destiné à être déposé (figure 14D).

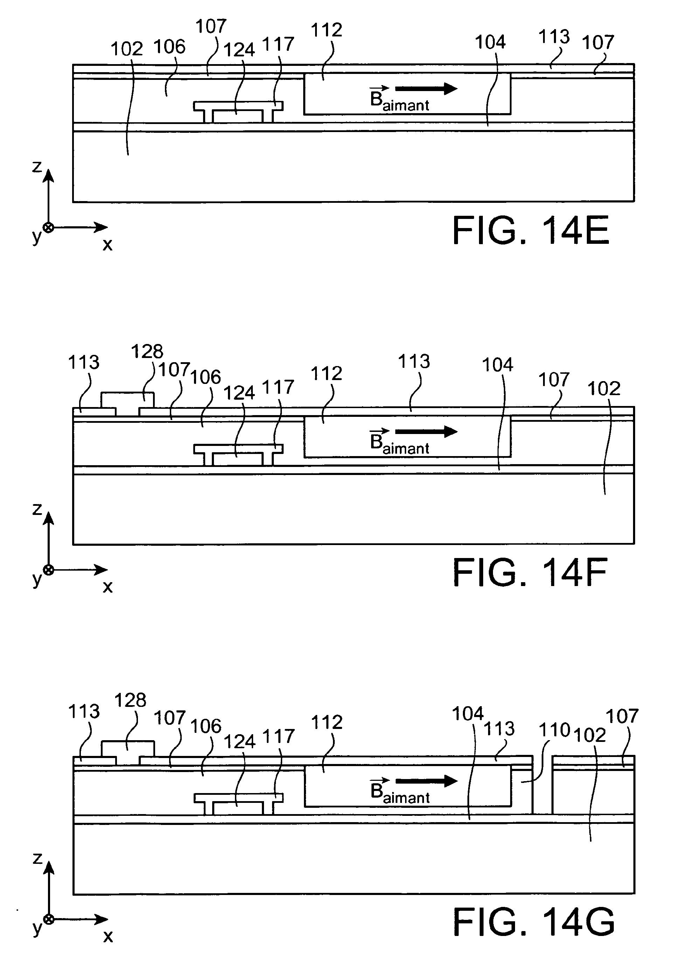

Le matériau ferromagnétique est ensuite déposé sur l'ensemble du dispositif afin de remplir notamment l'emplacement 111. Le matériau ferromagnétique se trouvant sur la couche de SiN 107 est ensuite supprimé par exemple par une planarisation mécano-chimique avec arrêt sur la couche de SiN 107 afin de ne conserver que le matériau ferromagnétique 112 se trouvant dans l'emplacement 111. On réalise ensuite un recuit et une aimantation du matériau ferromagnétique 112 afin de définir la direction d'aimantation B$_{aimant}$ du matériau 112, ici parallèle à l'axe X. On dépose ensuite une couche de passivation 113, par exemple à base de SiN et par exemple d'épaisseur égale à environ 0,3 $\mu$m, sur le dispositif (figure 14E).

On grave ensuite des portions de la couche de passivation 113 puis les contacts électriques 128 sont ensuite réalisées par dépôt de couches métalliques et gravure au niveau des portions précédemment gravées dans la couche de passivation 113 (figure 14F).

On réalise ensuite une gravure dans la couche de passivation 113 et dans la couche de silicium épitaxiée 106 afin de délimiter le caisson 110 ainsi que la charnière (non référencée) destinée à relier mécanique et former la liaison pivot entre le caisson 110 et le reste du dispositif (figure 14G).

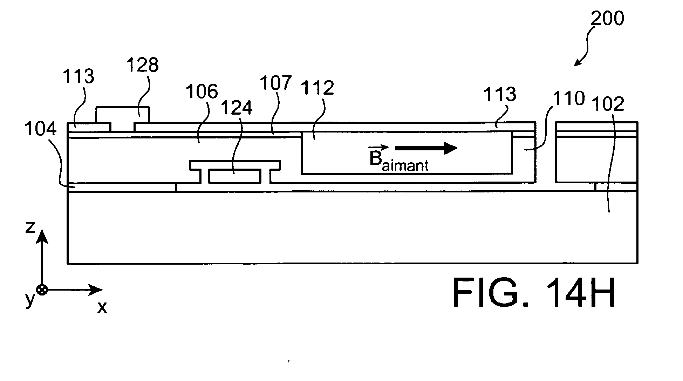

Des parties de la couche diélectrique 104 ainsi que la portion d'oxyde 117 sont ensuite gravées, par exemple par une gravure humide, afin de libérer le caisson 110, la jauge de contrainte 124 et la charnière du reste du capteur 200 (Figure 14H). Il est également possible de supprimer ensuite, par exemple par gravure, la couche de passivation 113.

Bien que décrit pour la réalisation du capteur 200, le procédé décrit ci-dessus pourrait également s'appliquer pour la réalisation des autres capteurs 100, 300, 400, 500 et 600 précédemment décrits.


### Revendications

**1.** Capteur (100, 200, 300, 400, 500, 602, 604, 604.1 - 604.3, 606) de champ magnétique comportant au moins :

- un corps (108, 508, 622, 702, 802) comprenant des moyens magnétiques (112, 512, 608, 610, 612, 620) aptes à former un couple s'exerçant sur le corps (108, 508, 622, 702, 802) sous l'action d'un champ magnétique extérieur à détecter,
- des moyens de liaison (116, 216, 516, 706, 806), distincts du corps (108, 508, 622, 702, 802), reliant mécaniquement le corps (108, 508, 622, 702, 802) à une portion d'encastrement (114, 514, 807) du capteur par au moins une liaison pivot d'axe perpendiculaire à la direction du champ magnétique à détecter,
- des moyens de détection d'une contrainte exercée par le corps (108, 508, 622, 702, 802) sous l'action du couple, distincts des moyens de liaison (116, 216, 516, 706, 806), comportant au moins une jauge de contrainte suspendue (124, 204, 524, 708a, 708b, 808a, 808b) dont au moins une première partie (123, 203) est reliée mécaniquement à la portion d'encastrement (114, 514, 807), au moins une deuxième partie (125, 205) étant reliée mécaniquement au corps (108, 508, 622, 702, 802), et dont au moins une troisième partie (127, 207) disposée entre la première (123, 203) et la deuxième partie (125, 205) est suspendue entre la portion d'encastrement (114, 514, 807) et le corps (108, 508, 622, 702, 802) et en contact avec aucun autre élément du capteur (100, 200, 300, 400, 500, 602, 604, 604.1 - 604.3, 606).

**2.** Capteur (100, 200, 300, 400, 500, 602, 604, 604.1 - 604.3, 606) selon la revendication 1, dans lequel la jauge de contrainte suspendue (124, 204, 524, 708a, 708b, 808a, 808b) est disposée en dehors de l'axe de la liaison pivot et/ou perpendiculairement à l'axe de la liaison pivot.

3. Capteur (100, 200, 300, 400, 500, 602, 604, 604.1, 606) selon l'une des revendications précédentes, dans lequel les moyens magnétiques comportent au moins un matériau ferromagnétique (112, 512, 608, 610, 612) dont la direction d'aimantation est perpendiculaire à la direction du champ magnétique à détecter et à l'axe de la liaison pivot, ou au moins une bobine (620) destinée à être traversée par un courant électrique dans un plan permettant de générer un champ magnétique induit de direction perpendiculaire à la direction du champ magnétique à détecter.

4. Capteur (100, 200, 300, 400, 500, 602, 604, 604.1, 606) selon la revendication 3, dans lequel le matériau ferromagnétique (112, 512, 608, 610, 612) est un matériau ferromagnétique doux.

5. Capteur (100, 200, 300, 400, 500, 602, 604, 604.1, 606) selon la revendication 4, comportant en outre des moyens d'aimantation du matériau ferromagnétique (112, 512, 608, 610, 612) tels que le matériau ferromagnétique (112, 512, 608, 610, 612) et lesdits moyens d'aimantation soient destinés à former un électroaimant.

6. Capteur (100, 200, 300, 400, 500, 602, 604, 604.1, 606) selon l'une des revendications 1 à 3, dans lequel les moyens magnétiques comportent un empilement d'une ou plusieurs couches de matériau ferromagnétique (902.1 - 902.4) disposées de manière alternée avec une ou plusieurs couches de matériau antiferromagnétique (904.1 - 904.5).

7. Capteur (100, 200, 300, 400, 500, 602, 604, 604.1, 606) selon la revendication 6, dans lequel chaque empilement de couches forme un ensemble de blocs (906.1, 906.2, 906.3) parallèles et disjoints entre eux.

8. Capteur (100, 200, 300, 400, 500, 602, 604, 604.1 - 604.3, 606) selon l'une des revendications précédentes, dans lequel le corps (108, 508, 622, 702, 802) comporte un caisson (110, 510) dans lequel sont disposés les moyens magnétiques (112, 512, 608, 610, 612) ou une face sur laquelle sont disposés les moyens magnétiques (620).

9. Capteur (100, 200, 300, 400, 500, 602, 604, 604.1 - 604.3, 606) selon l'une des revendications précédentes, les moyens de liaison comportant au moins une charnière (116, 216, 516, 706, 806).

10. Capteur (100, 200, 300, 400, 602, 604, 604.1 - 604.3, 606) selon la revendication 9, dans lequel le corps (108, 622, 702, 802) comporte deux faces principales (118, 120) parallèles l'une par rapport à l'autre, la charnière (116, 216, 706, 806) étant reliée à une autre face du corps (108, 622, 702, 802) sensiblement perpendiculaire aux deux faces principales du corps (108, 622, 702, 802).

11. Capteur (100, 200, 300, 400, 500, 602, 604, 604.1 - 604.3, 606) selon l'une des revendications précédentes, dans lequel la jauge de contrainte suspendue (124, 524, 708a, 708b, 808a, 808b) est de type piézorésistif et comporte au moins une poutre à base d'un matériau semi-conducteur ou à base d'un matériau métallique.

12. Capteur (100, 200, 300, 400, 500, 602, 604, 604.1 - 604.3, 606) selon la revendication 11, dans lequel les moyens de détection comportent en outre des moyens (126, 530, 532) de mesure de la résistance électrique de la jauge de contrainte suspendue (124, 524, 708a, 708b, 808a, 808b).

13. Capteur (200) selon l'une des revendications 1 à 10, dans lequel la jauge de contrainte suspendue est de type résonateur et comporte au moins une poutre vibrante (204), les moyens de détection comportant en outre des moyens d'excitation (202, 206) de la poutre vibrante (204) et des moyens de mesure (208, 210) d'une variation de la fréquence de vibration de la poutre (204).

14. Capteur (200) selon la revendication 13, dans lequel les moyens d'excitation de la poutre vibrante (204) comportent au moins un générateur de tension à composantes continue et/ou alternative (202) relié électriquement à au moins une électrode d'excitation (206) couplée à la poutre vibrante (204), et les moyens de mesure d'une variation de la fréquence de vibration de la poutre (204) comportent au moins des moyens de mesure (210) d'une variation de fréquence du potentiel électrique d'au moins une électrode de détection (208) couplée à la poutre vibrante (204).

15. Capteur (400) selon l'une des revendications précédentes, comportant en outre au moins une seconde jauge de contrainte (124b) suspendue entre la portion d'encastrement (114) et le corps (108), les deux jauges de contrainte suspendues (124a, 124b) étant disposées de part et d'autre de l'axe de la liaison pivot.

16. Capteur (500) selon l'une des revendications précédentes, comportant au moins une jauge de contrainte suspendue (524) entre la portion d'encastrement (514) et le corps (508) montée en pont de Wheatstone.

17. Capteur (300) selon l'une des revendications précédentes, comportant en outre :

- un second corps (108b) comprenant des seconds moyens magnétiques (112b) aptes à former un second couple s'exerçant sur le second corps (108b) sous l'action du champ magnétique à détecter de manière sensiblement similaire au premier corps (108a),
- des seconds moyens de liaison (116b) reliant mécaniquement le second corps (108b) à une portion d'encastrement (114b) du capteur (300) par au moins une liaison pivot d'axe perpendiculaire à la direction du champ magnétique à détecter,
- des seconds moyens de détection d'une contrainte exercée par le second corps (108b) sous l'action du second couple, comportant au moins une seconde jauge de contrainte (124b) suspendue entre la portion d'encastrement (114b) et le second corps (108b) et destinée à travailler de manière différentielle en compression ou tension par rapport à la première jauge de contrainte suspendue (124a) travaillant respectivement en tension ou en compression.

18. Capteur (500) selon l'une des revendications 1 à 16, dans lequel le corps (508), comporte deux faces principales (520) parallèles l'une par rapport à l'autre, et comporte un évidement (509) traversant les deux faces principales (520) et centré par rapport aux sections des deux faces principales (520),

le capteur (500) comportant en outre :

- au moins deux moyens de liaison (516a - 516d) reliant chacun mécaniquement une paroi du corps (508), chaque paroi étant perpendiculaire aux deux faces principales (520) du corps (508) et formant un côté de l'évidement (509), à la portion d'encastrement (514) du capteur (500) disposée dans l'évidement (509) par une liaison pivot d'axe perpendiculaire à la direction du champ magnétique à détecter et perpendiculaire aux deux faces principales (520) du corps (508),
- au moins une jauge de contrainte piézorésistive (524a - 524d) suspendue entre la portion d'encastrement (514) du capteur (500) et le corps (508).

19. Capteur (100, 200, 300, 400, 500, 602, 604, 604.1 - 604.3, 606) selon l'une des revendications précédentes, le capteur étant de type MEMS et/ou NEMS.

20. Capteur (100, 200, 300, 400, 500, 602, 604, 604.1 - 604.3, 606) selon l'une des revendications précédentes, dans lequel le corps (702, 802) a une forme telle que le centre de gravité du corps (702, 802) soit sensiblement proche de l'axe de la liaison pivot.

21. Capteur (100, 200, 300, 400, 500, 602, 604, 604.1 - 604.3, 606) selon l'une des revendications précédentes, dans lequel le centre de gravité des moyens magnétiques (112, 512, 608, 610, 612, 620) est sensiblement proche de l'axe de la liaison pivot.

22. Capteur (600) de champ magnétique à deux ou trois directions comportant respectivement deux ou trois capteurs magnétiques (602, 604, 604.1 - 604.2, 606) selon l'une des revendications 1 à 21, les capteurs magnétiques (602, 604, 604.1 - 604.2, 606) étant disposés tels que les directions des champs magnétiques destinées à être mesurés par ces capteurs (602, 604, 604.1 - 604.2, 606) sont perpendiculaires les unes par rapport aux autres.

23. Capteur (600) de champ magnétique à trois directions selon la revendication 22, dans lequel les axes des liaisons pivot de deux des capteurs magnétiques (604, 604.1 - 604.2, 606) sont perpendiculaires par rapport à l'axe de la liaison pivot du troisième capteur magnétique (602).

24. Capteur (600) selon la revendication 23, dans lequel chaque capteur magnétique (602, 604, 606) comporte au moins un matériau ferromagnétique dont la direction d'aimantation est perpendiculaire à la direction de la composante du champ magnétique à détecter par ledit capteur (602, 604, 606) et perpendiculaire à l'axe de la liaison pivot dudit capteur (602, 604, 606).

25. Capteur (600) selon la revendication 23, dans lequel chaque capteur magnétique (602, 604.1 - 604.3) comporte au moins un matériau ferromagnétique (610, 612) dont la direction d'aimantation est perpendiculaire à l'axe de la liaison pivot dudit capteur (602, 604.1 - 604.3), les directions d'aimantation des matériaux ferromagnétiques (610, 612) des trois capteurs magnétiques (602, 604.1 - 604.3) étant similaires, et comportant en outre au moins un guide de flux magnétique (650, 660) apte à réorienter des lignes de champ magnétique selon une première direction perpendiculaire à la direction initiale desdites lignes de champ, ledit guide de flux magnétique (650, 660) étant couplé à l'un des trois capteurs magnétiques (604.2) tel que ce capteur (604.2) puisse mesurer le champ magnétique formé par lesdites lignes de champ réorientées.

26. Capteur (600) selon la revendication 25, comportant en outre au moins un quatrième capteur magnétique (604.3) similaire au capteur (604.2) auquel est couplé le guide de flux magnétique (660), ledit guide de flux magnétique (660) étant apte à réorienter des lignes de champ magnétique selon une seconde direction perpendiculaire à la direction initiale desdites lignes de champ et opposée à la première direction de réorientation des lignes de champ, le guide de flux magnétique (660) étant en outre couplé au quatrième capteur magnétique (604.3) tel que ce quatrième capteur (604.3) puisse mesurer le champ magnétique formé par lesdites lignes de champ réorientées selon la seconde direction.

27. Capteur (600) selon l'une des revendications 25 ou 26, dans lequel le guide de flux magnétique (650, 660) comporte au moins un élément d'amplification (652, 662.1, 662.2) de lignes de champ magnétique.

28. Procédé de réalisation d'un capteur (100, 200, 300, 400, 500, 602, 604, 604.1 - 604.3, 606) de champ magnétique comportant au moins les étapes de :

   - réalisation d'un corps (108, 508, 622, 702, 802) comprenant des moyens magnétiques (112, 512, 608, 610, 612, 620) aptes à former un couple s'exerçant sur le corps (108, 508, 622, 702, 802) sous l'action d'un champ magnétique extérieur à détecter,
   - réalisation de moyens de liaison (116, 216, 516, 706, 806), distincts du corps (108, 508, 622, 702, 802), reliant mécaniquement le corps (108, 508, 622, 702, 802) à une portion d'encastrement (114, 514, 807) du capteur par au moins une liaison pivot d'axe perpendiculaire à la direction du champ magnétique à détecter,
   - réalisation de moyens de détection d'une contrainte exercée par le corps (108, 508, 622, 702, 802) sous l'action du couple, distincts des moyens de liaison (116, 216, 516, 706, 806), comportant au moins une jauge de contrainte suspendue (124, 204, 524, 708a, 708b, 808a, 808b) dont au moins une première partie est reliée mécaniquement à la portion d'encastrement (114, 514, 807), au moins une deuxième partie étant reliée mécaniquement au corps (108, 508, 622, 702, 802), et dont au moins une troisième partie disposée entre la première et la deuxième partie est suspendue entre la portion d'encastrement (114, 514, 807) et le corps (108, 508, 622, 702, 802) <u>et en contact avec aucun autre élément du capteur (100, 200, 300, 400, 500, 602, 604, 604.1 - 609.3, 606) .</u>

**Claims**

1. A magnetic field sensor (100, 200, 300, 400, 500, 602, 604, 604.1 - 604.3, 606) having at least:

   - a body (108, 508, 622, 702, 802) including magnetic means (112, 512, 608, 610, 612, 620) capable of forming a torque applied on the body (108, 508, 622, 702, 802) by the action of an external magnetic field to be detected,
   - connection means (116, 216, 516, 706, 806), separated from the body (108, 508, 622, 702, 802), mechanically connecting the body (108, 508, 622, 702, 802) to an inlay portion (114, 514, 807) of the sensor by at least one pivot link having an axis perpendicular to the direction of the magnetic field to be detected,
   - means for detecting a stress applied by the body (108, 508, 622, 702, 802) by the action of the torque, separated from the connection means (116, 216, 516, 706, 806) and including at least one suspended stress gauge (124, 204, 524, 708a, 708b, 808a, 808b) having at least a first part (123, 203) mechanically connected to the inlay portion (114, 514, 807), at least a second part (125, 205) mechanically connected to the body (108, 508, 622, 702, 802), as well as at least a third part (127, 207) provided between the first (123, 203) and second parts (125, 205) is suspended between the inlay portion (114, 514, 807) and the body (108, 508, 622, 702, 802) and in contact with no other element of the sensor (100, 200, 300 400, 500, 602, 604.1 - 604.3, 606).

2. The sensor (100, 200, 300, 400, 500, 602, 604, 604.1 - 604.3, 606) according to claim 1, wherein the suspended stress gauge (124, 204, 524, 708a, 708b, 808a, 808b) is arranged outside the axis of the pivot link and/or perpendicular to the axis of pivot link.

3. The sensor (100, 200, 300, 400, 500, 602, 604, 604.1, 606) according to one of the preceding claims, wherein the magnetic means have at least one ferromagnetic material (112, 512, 608, 610, 612) whereof the direction of magnetization is perpendicular to the direction of magnetic field to be detected and the axis of the pivot link, or at least one coil (620) intended to be passed through by an electric current in a plane making it possible to generate an induced magnetic field with a direction perpendicular to the direction of the magnetic field to be detected.

4. The sensor (100, 200, 300, 400, 500, 602, 604, 604.1, 606) according to claim 3, wherein the ferromagnetic material (112, 512, 608, 610, 612) is a soft ferromagnetic material.

5. The sensor (100, 200, 300, 400, 500, 602, 604, 604.1, 606) according to claim 4, also having magnetization means for the ferromagnetic material (112, 512, 608, 610, 612) such as ferromagnetic material (112, 512, 608, 610, 612) and said magnetization means are intended to form an electromagnet.

6. The sensor (100, 200, 300, 400, 500, 602, 604, 604.1, 606) according to one of claims 1 to 3, wherein the magnetic means has a stack of one or more layers of ferromagnetic material (902.1 - 902.4) arranged to alternate with one or more layers of antiferromagnetic material (904.1 - 904.5).

7. The sensor (100, 200, 300, 400, 500, 602, 604, 604.1, 606) according to claim 6, wherein each stack of layers forms a set of parallel blocks (906.1, 906.2, 906.3) detached from each other.

8. The sensor (100, 200, 300, 400, 500, 602, 604, 604.1 - 604.3, 606) according to one of the preceding claims, wherein the body (108, 508, 622, 702, 802) has a box (110, 510) in which the magnetic means (112, 512, 608, 610, 612) are arranged or a face on which the magnetic means (620) are arranged.

9. The sensor (100, 200, 300, 400, 500, 602, 604, 604.1 - 604.3, 606) according to one of the preceding claims, the connection means having at least one hinge (116, 216, 516, 706, 806).

10. The sensor (100, 200, 300, 400, 602, 504, 604.1 - 604.3, 606) according to claim 9, wherein the body (108, 622, 702, 802) has two main faces (118, 120) parallel to each other, the hinge (116, 216, 706, 806) being connected to another face of the body (108, 622, 702, 802) substantially perpendicular to the two main faces of the body (108, 622, 702, 802).

11. The sensor (100, 200, 300, 400, 500, 602, 604, 604.1 - 604.3, 606) according to one of the preceding claims, wherein the suspended stress gauge (124, 524, 708a, 708b, 808a, 808b) is of the piezoresistive type and has at least one beam composed of a semiconductor material or a metal material.

12. The sensor (100, 200, 300, 400, 500, 602, 604, 604.1 - 604.3, 606) according to claim 11, wherein the detection means also have means (126, 530, 532) for measuring the electrical resistance of the suspended stress gauge (124, 524, 708a, 708b, 808a, 808b).

13. The sensor (200) according to one of claims 1 to 10, wherein the suspended stress gauge is of the resonator type and has at least one vibrating beam (204), the detection means also having means (202, 206) for exciting the vibrating beam (204) and means (208, 210) for measuring a variation in the vibration frequency of the beam (204).

14. The sensor (200) according to claim 13, wherein the means for exciting the vibrating beam (204) have at least one voltage generator with direct and/or alternating components (202) electrically connected to at least one excitation electrode (206) coupled to the vibrating beam (204), and the means for measuring a variation in the vibration frequency of the beam (204) have at least one means (210) for measuring a frequency variation of the electrical potential of at least one detection electrode (208) coupled to the vibrating beam (204).

15. The sensor (400) according to one of the preceding claims, also having at least one second stress gauge (124b) suspended between the inlay portion (114) and the body (108), the two suspended stress gauges (124a, 124b) being arranged on either side of the axis of the pivot link.

16. The sensor (500) according to one of the preceding claims, having at least one stress gauge (524) suspended between the inlay portion (514) and the body (508) mounted in a Wheatstone bridge.

17. The sensor (300) according to one of the preceding claims, also having:

- a second body (108b) comprising second magnetic means (112b) able to form a second torque applied on the second body (108b) by the action of the magnetic field to be detected substantially similarly to the first body (108a),

- second connection means (116b) mechanically connecting the second body (108b) to an inlay portion (114b) of the sensor (300) by at least one pivot link with an axis perpendicular to the direction of the magnetic field to be detected,
- second means for detecting a stress applied by the second body (108b) by the action of the second torque, having at least one second stress gauge (124b) suspended between the inlay portion (114b) and the second body (108b) and intended to work differentially in compression or tension relative to the first suspended stress gauge (124a) working in tension or compression, respectively.

18. The sensor (500) according to one of claims 1 to 16, in which the body (508) has two parallel main faces (520), and has a recess (509) passing through the two main faces (520) and centered relative to the sections of the two main faces (520),

the sensor (500) also having:

- at least two connection means (516a - 516d) each mechanically connecting a wall of the body (508) , each wall being perpendicular to the two main faces (520) of the body (508) and forming a side of the recess (509), to the inlay portion (514) of the sensor (500) arranged in the recess (509) by a pivot link having an axis perpendicular to the direction of the magnetic field to be detected and perpendicular to the two main faces (520) of the body (508),
- at least one piezoresistive stress gauge (524a - 524d) suspended between the inlay portion (514) of the sensor (500) and the body (508).

19. The sensor (100, 200, 300, 400, 500, 602, 604, 604.1 - 604.3, 606) according to one of the preceding claims, the sensor being of the MEMS and/or NEMS type.

20. The sensor (100, 200, 300, 400, 500, 602, 604, 604.1 - 604.3, 606) according to one of the preceding claims, wherein the body (702, 802) has a shape such that the center of gravity of the body (702, 802) is substantially close to the axis of the pivot link.

21. The sensor (100, 200, 300, 400, 500, 602, 604, 604.1 - 604.3, 606) according to one of the preceding claims, wherein the center of gravity of the magnetic means (112, 512, 608, 610, 612, 620) is substantially close to the axis of the pivot link.

22. A magnetic field sensor (600) with two or three directions respectively having two or three magnetic sensors (602, 604, 604.1 - 604.2, 606) according to one of claims 1 to 21, the magnetic sensors (602, 604, 604.1 - 604.2, 606) being arranged so that the directions of the magnetic fields intended to be measured by these sensors (602, 604, 604.1 604.2, 606) are perpendicular to each other.

23. The three-direction magnetic field sensor (600) according to claim 22, wherein the axes of the pivot links of two of the magnetic sensors (604, 604.1 - 604.2, 606) are perpendicular to the axis of the pivot link of the third magnetic sensor (602).

24. The sensor (600) according to claim 23, wherein each magnetic sensor (602, 604, 606) has at least one ferromagnetic material, the magnetization direction of which is perpendicular to the direction of the component of the magnetic field to be detected by said sensor (602, 604, 606) and perpendicular to the axis of the pivot link of said sensor (602, 604, 606).

25. The sensor (600) according to claim 23, wherein each magnetic sensor (602, 604.1 - 604.3) has at least one ferromagnetic material (610, 612) whereof the magnetization direction is perpendicular to the axis of the pivot link of said sensor (602, 604.1 - 604.3), the magnetization directions of the ferromagnetic materials (610, 612) of the three magnetic sensors (602, 604.1 - 604.3) being similar, and also having at least one magnetic flux guide (650, 660) able to reorient magnetic field lines in a first direction perpendicular to the initial direction of said field lines, said magnetic flux guide (650, 660) being coupled to one of the three magnetic sensors (604.2) such that this sensor (604.2) can measure the magnetic field formed by said reoriented field lines.

26. The sensor (600) according to claim 25, also having at least one fourth magnetic sensor (604.3) similar to the sensor (604.2) to which the magnetic flux guide (660) is coupled, said magnetic flux guide (660) being able to orient the magnetic field lines in a second direction perpendicular to the initial direction of said field lines and opposite the first reorientation direction of the field lines, the magnetic flux guide (660) also being coupled to the fourth magnetic sensor (604.3) such that the fourth sensor (604.3) can measure the magnetic field formed by said reoriented field lines in the second direction.

27. The sensor (600) according to one of claims 25 or 26, wherein the magnetic flux guide (650, 660) has at least one magnetic field lines amplification element (652, 662.1, 662.2).

28. A method of making a magnetic field sensor (100, 200, 300, 400, 500, 602, 604, 604.1 - 604.3, 606) including at least the following steps:

- making a body (108, 508, 622, 702, 802) comprising magnetic means (112, 512, 608, 610, 612, 620) able to form a torque applied on the body (108, 508, 622, 702, 802) by the action of an outside magnetic field to be detected,
- making connecting means (116, 216, 516, 706, 806), separated from the body (108, 508, 622, 702, 802), mechanically connecting the body (108, 508, 622, 702, 802) to an inlay portion (114, 514, 807) of the sensor by at least one pivot link having an axis perpendicular to the direction of the magnetic field to be detected,
- making means for detecting a stress applied by the body (108, 508, 622, 702, 802) by the action of the torque, separated from the connection means (116, 216, 516, 706, 806), having at least one suspended stress gauge (124, 204, 524, 708a, 708b, 808a, 808b) whereof at least a first part is mechanically connected to the inlay portion (114, 514, 807), at least one second part being mechanically connected to the body (108, 508, 622, 702, 802), and at leat a third part arranged between the first and second parts is suspended between the inlay portion (114, 514, 807) and the body (108, 508, 622, 702, 802) and in contact with no other element of the sensor (100, 200, 300 400, 500, 602, 604.1 - 604.3, 606).

**Patentansprüche**

1. Magnetfeldsensor (100, 200, 300, 400, 500, 602, 604, 604.1 bis 604.3, 606), der mindestens Folgendes umfasst:

- einen Körper (108, 508, 622, 702, 802), der magnetische Mittel (112, 512, 608, 610, 612, 620) umfasst, die geeignet sind, ein Drehmoment zu bilden, das unter der Winkung eines zu ermittelnden äußeren Magnetfelds auf den Körper (108, 508, 622, 702, 802) ausgeübt wird,
- Verbindungsmittel (116, 216, 516, 706, 806), die sich vom Körper (108, 508, 622, 702, 802) unterscheiden und den Körper (108, 508, 622, 702, 802) durch mindestens eine Schwenkverbindung mit einer Achse, die senkrecht zur Richtung des zu ermittelnden Magnetfelds ist, mechanisch mit einem Einbauabschnitt (114, 514, 807) des Sensors verbinden,
- Mittel zur Ermittlung einer durch den Körper (108, 508, 622, 702, 802) unter der Wirkung des Drehmoments ausgeübten Spannung, die sich von den Verbindungsmitteln (116, 216, 516, 706, 806) unterscheiden und mindestens einen aufgehängten Dehnungsmessstreifen (124, 204, 524, 708a, 708b, 808a, 808b) umfassen, von dem zumindest ein erster Abschnitt (123, 203) mechanisch mit dem Einbauabschnitt (114, 514, 807) verbunden ist, zumindest ein zweiter Abschnitt (125, 205) mechanisch mit dem Körper (108, 508, 622, 702, 802) verbunden ist und von dem zumindest ein dritter Abschnitt (127, 207), der zwischen dem ersten (123, 203) und dem zweiten Abschnitt (125, 205) angeordnet ist, zwischen dem Einbauabschnitt (114, 514, 807) und dem Körper (108, 508, 622, 702, 802) aufgehängt ist und mit keinem anderen Element des Sensors (100, 200, 300, 400, 500, 602, 604, 604.1 bis 604.3, 606) in Berührung ist.

2. Sensor (100, 200, 300, 400, 500, 602, 604, 604.1 bis 604.3, 606) nach Anspruch 1, wobei der aufgehängte Dehnungsmessstreifen (124, 204, 524, 708a, 708b, 808a, 808b) außerhalb der Achse der Schwenkverbindung und/oder senkrecht zur Achse der Schwenkverbindung angeordnet ist.

3. Sensor (100, 200, 300, 400, 500, 602, 604, 604.1, 606) nach einem der vorhergehenden Ansprüche, wobei die magnetischen Mittel mindestens ein ferromagnetisches Material (112, 512, 608, 610, 612), dessen Magnetisierungsrichtung senkrecht zur Richtung des zu ermittelten Magnetfelds und zur Achse der Schwenkverbindung ist, oder mindestens eine Spule (620) umfasst, die dazu bestimmt ist, in einer Ebene durch einen elektrischen Strom durchflossen zu werden, der das Erzeugen eines induzierten Magnetfelds mit einer Richtung senkrecht zur Richtung des zu ermittelnden Magnetfelds ermöglicht.

4. Sensor (100, 200, 300, 400, 500, 602, 604, 604.1, 606) nach Anspruch 3, wobei das ferromagnetische Material (112, 512, 608, 610, 612) ein weichferromagnetisches Material ist.

5. Sensor (100, 200, 300, 400, 500, 602, 604, 604.1, 606) nach Anspruch 4, das ferner Mittel zur Magnetisierung des ferromagnetischen Materials (112, 512, 608, 610, 612), wie des ferromagnetischen Materiales (112, 512, 608, 610, 612), umfasst und wobei die Magnetisierungsmittel dazu bestimmt sind, einen Elektromagneten zu bilden.

6. Sensor (100, 200, 300, 400, 500, 602, 604, 604.1, 606) nach einem der Ansprüche 1 bis 3, wobei die magnetischen Mittel einen Stapel aus einer oder mehreren Schichten aus ferromagnetischem Material (902.1 bis 902.4) umfassen, die abwechselnd mit einer oder mehreren Schichten aus antiferromagnetischem Material (904.1 bis 904.5) angeordnet sind.

7. Sensor (100, 200, 300, 400, 500, 602, 604, 604.1, 606) nach Anspruch 6, wobei jeder Stapel aus Schichten eine Gruppe von Blöcken (906.1, 906.2, 906.3) bildet, die untereinander parallel und voneinander getrennt sind.

8. Sensor (100, 200, 300, 400, 500, 602, 604, 604.1 bis 604.3, 606) nach einem der vorhergehenden Ansprüche, wobei der Körper (108, 508, 622, 702, 802) einen Kasten (110, 510), in dem die magnetischen Mittel (112, 512, 608, 610, 612) angeordnet sind, oder eine Seite umfasst, auf der die magnetischen Mittel (620) angeordnet sind.

9. Sensor (100, 200, 300, 400, 500, 602, 604, 604.1 bis 604.3, 606) nach einem der vorhergehenden Ansprüche, wobei die Verbindungsmittel mindestens ein Scharnier (116, 216, 516, 706, 806) umfassen.

10. Sensor (100, 200, 300, 400, 602, 604, 604.1 bis 604.3, 606) nach Anspruch 9, wobei der Körper (108, 622, 702, 802) zwei Hauptseiten (118, 120) umfasst, die zueinander parallel sind, wobei das Scharnier (116, 216, 706, 806) mit einer anderen Seite des Körpers (108, 622, 702, 802) verbunden ist, die im Wesentlichen senkrecht zu den zwei Hauptseiten des Körpers (108, 622, 702, 802) ist.

11. Sensor (100, 200, 300, 400, 500, 602, 604, 604.1 bis 604.3, 606) nach einem der vorhergehenden Ansprüche, wobei der aufgehängte Dehnungsmessstreifen (124, 524, 708a, 708b, 808a, 808b) vom piezoresistiven Typ ist und mindestens einen Balken umfasst, der auf einem Halbleitermaterial basiert oder auf einem metallischen Material basiert.

12. Sensor (100, 200, 300, 400, 500, 602, 604, 604.1 bis 604.3, 606) nach Anspruch 11, wobei die Ermittlungsmittel ferner Mittel (126, 530, 532) zum Messen des elektrischen Widerstands des aufgehängten Dehnungsmessstreifens (124, 524, 708a, 708b, 808a, 808b) umfassen.

13. Sensor (200) nach einem der Ansprüche 1 bis 10, wobei der aufgehängte Dehnungsmessstreifen vom Resonatortyp ist und mindestens einen schwingenden Balken (204) umfasst, wobei die Ermittlungsmittel ferner Mittel zur Anregung (202, 206) des schwingenden Balkens (204) und Mittel zum Messen (208, 210) einer Veränderung der Schwingungsfrequenz des Balkens (204) umfassen.

14. Sensor (200) nach Anspruch 13, wobei die Mittel zur Anregung des schwingenden Balkens (204) mindestens einen Generator für Spannung mit Gleichspannungs- und/oder Wechselspannungsanteilen (202) umfassen, der elektrisch mit mindestens einer Anregungselektrode (206) verbunden ist, die an den vibrierenden Balken (204) gekoppelt ist, und die Mittel zur Messung einer Veränderung der Schwingungsfrequenz des Balkens (204) mindestens Mittel (210) zur Messung einer Veränderung der Frequenz des elektrischen Potentials von mindestens einer Sensorelektrode (208), die an den schwingenden Balken (204) gekoppelt ist, umfassen.

15. Sensor (400) nach einem der vorhergehenden Ansprüche, der ferner mindestens einen zweiten Dehnungsmessstreifen (124b) umfasst, der zwischen dem Einbauabschnitt (114) und dem Körper (108) aufgehängt ist, wobei die zwei aufgehängten Dehnungsmessstreifen (124a, 124b) auf beiden Seiten der Achse der Schwenkverbindung angeordnet sind.

16. Sensor (500) nach einem der vorhergehenden Ansprüche, der mindestens einen Dehnungsmessstreifen (524) umfasst, der zwischen dem Einbauabschnitt (514) und dem Körper (508) aufgehängt und als Wheatstone-Brücke geschaltet ist.

17. Sensor (300) nach einem der vorhergehenden Anspruche, der ferner Folgendes umfasst:

- einen zweiten Körper (108b), der zweite magnetische Mittel (112b) umfasst, die geeignet sind, ein zweites Drehmoment zu bilden, das unter der Winkung des zu ermittelnden Magnetfelds auf im Wesentlichen dem ersten Körper (108a) ähnliche Weise auf den zweiten Körper (108b) ausgeübt wird,

- zweite Verbindungsmittel (116b), die den zweiten Körper (108b) durch mindestens eine Schwenkverbindung mit einer Achse, die senkrecht zur Richtung des zu ermittelnden Magnetfelds ist, mechanisch mit einem Einbauabschnitt (114b) des Sensors (300) verbinden,

- zweite Mittel zur Ermittlung einer durch den zweiten Körper (108b) unter der Winkung des zweiten Drehmoments ausgeübten Spannung, die mindestens einen zweiten Dehnungsmessstreifen (124b) umfassen, der zwischen dem Einbauabschnitt (114b) und dem zweiten Körper (108b) aufgehängt ist und dazu bestimmt ist, beim Zusammendrücken oder Spannen auf differentielle Weise in Bezug zum ersten aufgehängten Dehnungsmessstreifen (124a) zu wirken, der beim Spannen beziehungsweise Zusammendrücken wirkt.

18. Sensor (500) nach einem der Ansprüche 1 bis 16, wobei der Körper (508) zwei Hauptseiten (520) umfasst, die zueinander parallel sind, und eine Aussparung (509) umfasst, die die zwei Hauptseiten (520) durchquert und in Bezug zu den Querschnitten der zwei Hauptseiten (520) zentriert ist,

wobei der Sensor (500) ferner Folgendes umfasst:

- mindestens zwei Verbindungsmittel (516a bis 516d), die jedes eine Wand des Körpers (508), wobei jede Wand senkrecht zu den zwei Hauptseiten (520) des Körpers (508) ist und eine Seite der Aussparung (509) bildet, durch eine Schwenkverbindung, deren Achse senkrecht zur Richtung des zu ermittelnden Magnetfelds und senkrecht zu den zwei Hauptseiten (520) des Körpers (508) ist, mechanisch mit dem in der Aussparung (509) angeordneten Einbauabschnitt (514) des Sensors (500) verbinden,

- mindestens einen piezoresistiven Dehnungsmessstreifen (524a bis 524d), der zwischen dem Einbauabschnitt (514) des Sensors (500) und dem Körper (508) aufgehängt ist.

19. Sensor (100, 200, 300, 400, 500, 602, 604, 604.1 bis 604.3, 606) nach einem der vorhergehenden Absprüche, wobei der Sensor vom Typ MEMS und/oder NEMS ist.

20. Sensor (100, 200, 300, 400, 500, 602, 604, 604.1 bis 604.3, 606) nach einem der vorhergehenden Ansprüche, wobei der Körper (702, 802) eine Form aufweist, die derart ist, dass der Schwerpunkt des Körpers (702, 802) sich im Wesentlichen in der Nähe der Achse der Schwenkverbindung befindet.

21. Sensor (100, 200, 300, 400, 500, 602, 604, 604.1 bis 604.3, 606) nach einem der vorhergehenden Ansprüche, wobei der Schwerpunkt der magnetischen Mittel (112, 512, 608, 610, 612, 620) sich im Wesentlichen in der Nähe der Achse der Schwenkverbindung befindet.

22. Magnetfeldsensor (600) mit zwei oder drei Richtungen, der zwei beziehungsweise drei Magnetfeldsensoren (602, 604, 604.1 bis 604.2, 606) nach einem der Ansprüche 1 bis 21 umfasst, wobei die Magnetfeldsensoren (602, 604, 604.1 bis 604.2, 606) derart angeordnet sind, dass die Richtungen der Magnetfelder, die dazu bestimmt sind, durch diese Sensoren (602, 604, 604.1 bis 604.2, 606) gemessen zu werden, in Bezug zu den anderen senkrecht sind.

23. Magnetfeldsensor (600) mit drei Richtungen nach Anspruch 22, wobei die Achsen der Schwenkverbindungen von zwei der Magnetsensoren (604, 604.1 bis 604.2, 606) in Bezug zur Achse der Schwenkverbindung des dritten Magnetsensors (602) senkrecht sind.

24. Sensor (600) nach Anspruch 23, wobei jeder Magnetsensor (602, 604, 606) mindestens ein ferromagnetisches Material umfasst, dessen Magnetisierungsrichtung senkrecht zur Richtung der durch den Sensor (602, 604, 606) zu ermittelnden Magnetfeldkomponente und senkrecht zur Achse der Schwenkverbindung des Sensors (602, 604, 606) ist.

25. Sensor (600) nach Anspruch 23, wobei jeder Magnetsensor (602, 604.1 bis 604.3) mindestens ein ferromagnetisches Material (610, 612) umfasst, dessen Magnetisierungsrichtung senkrecht zur Achse der Schwenkverbindung des Sensors (602, 604.1 bis 604.3) ist, wobei die Magnetisierungsrichtungen der ferromagnetischen Materialien (610, 612) der drei Magnetsensoren (602, 604.1 bis 604.3) ähnlich sind und ferner mindestens einen Magnetflussleiter (650, 660) umfassen, der geeignet ist, Magnetfeldlinien gemäß einer ersten Richtung neu auszurichten, die senkrecht zur Ausgangsrichtung der Feldlinien ist, wobei der Magnetflussleiter (650, 660) derart an einen der drei Magnetsensoren (604.2) gekoppelt ist, dass dieser Sensor (604.2) das Magnetfeld, das durch die neu ausgerichteten Feldlinien gebildet wird, messen kann.

**26.** Sensor (600) nach Anspruch 25, der ferner mindestens einen vierten Magnetsensor (604.3) umfasst, der dem Sensor (604.2) ähnlich ist, an den der Magnetflussleiter (660) gekoppelt ist, wobei der Magnetflussleiter (660) geeignet ist, Magnetflusslinien gemäß einer zweiten Richtung neu auszurichten, die senkrecht zur Ausgangsrichtung der Feldlinien ist und der ersten Neuausrichtungsrichtung der Feldlinien entgegengesetzt ist, wobei der Magnetflussleiter (660) ferner derart an den vierten Magnetsensor (604.3) gekoppelt ist, dass dieser vierte Sensor (604.3) das durch die gemäß der zweiten Richtung neu ausgerichteten Feldlinien gebildete Magnetfeld messen kann.

**27.** Sensor (600) nach einem der Ansprüche 25 oder 26, wobei der Magnetflussleiter (650, 660) mindestens ein Element (652, 662.1, 662.2) zur Verstärkung von Magnetfeldlinien umfasst.

**28.** Verfahren zum Ausführen eines Magnetfeldsensors (100, 200, 300, 400, 500, 602, 604, 604.1 bis 604.3, 606), das mindestens die folgenden Schritte umfasst:

- Ausführen eines Körpers (108, 508, 622, 702, 802), der magnetische Mittel (112, 512, 608, 610, 612, 620) umfasst, die geeignet sind, ein Drehmoment zu bilden, das unter der Winkung eines zu ermittelnden äußeren Magnetfelds auf den Körper (108, 508, 622, 702, 802) ausgeübt wird,
- Ausführen von Verbindungsmitteln (116, 216, 516, 706, 806), die sich vom Körper (108, 508, 622, 702, 802) unterscheiden und den Körper (108, 508, 622, 702, 802) durch mindestens eine Schwenkverbindung mit einer Achse, die senkrecht zur Richtung des zu ermittelnden Magnetfelds ist, mechanisch mit einem Einbauabschnitt (114, 514, 807) des Sensors verbinden,
- Ausführen von Mitteln zur Ermittlung einer durch den Körper (108, 508, 622, 702, 802) unter der Wirkung des Drehmoments ausgeübten Spannung, die sich von den Verbindungsmitteln (110, 216, 516, 706, 806) unterscheiden und mindestens einen aufgehängten Dehnungsmessstreifen (124, 204, 524, 708a, 708b, 808a, 808b) umfassen, von dem zumindest ein erster Abschnitt mechanisch mit dem Einbauabschnitt (114, 514, 807) verbunden ist, zumindest ein zweiter Abschnitt mechanisch mit dem Körper (108, 508, 622, 702, 802) verbunden ist und von dem zumindest ein dritter Abschnitt, der zwischen dem ersten und dem zweiten Abschnitt angeordnet ist, zwischen dem Einbauabschnitt (114, 514, 807) und dem Körper (108, 508, 622, 702, 802) aufgehängt ist und mit keinem anderen Element des Sensors (100, 200, 300, 400, 500, 602, 604, 604.1 bis 604.3, 606) in Berührung ist.

FIG. 1A

FIG. 1B

$$\vec{B}_{aimant}$$

$$\vec{B}_{ext_2}$$

$$\vec{F}_2$$

**FIG. 2A**

$$\vec{B}_{aimant}$$

$$\vec{B}_{ext_2}$$

$$\vec{F}_2$$

**FIG. 2B**

FIG. 3

FIG. 4

FIG. 5A

FIG. 5B

FIG. 6A

FIG. 6B

FIG. 7

FIG. 8

FIG. 9A

FIG. 9B

W

904.1
902.1
904.2
902.2
904.3
902.3
904.4
902.4
904.5

t'

t

z

y        x

# FIG. 10A

906.1        906.2        906.3

904.1
902.1
904.2
902.2
904.3
902.3
904.4
902.4
904.5

Wi

z

y        x

# FIG. 10B

FIG. 11A

FIG. 11B

**FIG. 12A**

**FIG. 12B**

102     104     106     107

# FIG. 13A

102     104     116         106     107

# FIG. 13B

102     104     116         106     107

# FIG. 13C

102     104     116   109       106     107

# FIG. 13D

FIG. 13E

FIG. 13F

FIG. 13G

FIG. 13H

FIG. 13I

FIG. 13J

FIG. 14A

FIG. 14B

FIG. 14C

FIG. 14D

FIG. 14E

FIG. 14F

FIG. 14G

44

FIG. 14H

**EP 2 382 481 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2006076947 A
- WO 0167122 A
- US 2003020472 A